(19) Europäisches Patentamt
European Patent Office
Office européen des brevets

(11) EP 1 247 146 B1

(12) EUROPÄISCHE PATENTSCHRIFT

(45) Veröffentlichungstag und Bekanntmachung des Hinweises auf die Patenterteilung:
**02.03.2005 Patentblatt 2005/09**

(21) Anmeldenummer: **00991572.9**

(22) Anmeldetag: **21.12.2000**

(51) Int Cl.[7]: **G05B 19/042**, H03M 13/35, B60T 8/88

(86) Internationale Anmeldenummer:
**PCT/DE2000/004640**

(87) Internationale Veröffentlichungsnummer:
**WO 2001/052003 (19.07.2001 Gazette 2001/29)**

(54) **CODIERVERFAHREN ZUR CODIERUNG VON AKTOREN-STEUERBEFEHLEN UND AKTORENSTEUEREINHEIT ZUR STEUERUNG VON AKTOREN**

CODING METHOD FOR CODING CONTROL COMMANDS FOR ACTUATORS AND ACTUATOR CONTROL UNIT FOR CONTROLLING ACTUATORS

PROCEDE DE CODAGE PERMETTANT DE CODER DES ORDRES DE COMMANDE D'ACTIONNEURS ET UNITE DE COMMANDE D'ACTIONNEURS PERMETTANT DE COMMANDER DES ACTIONNEURS

(84) Benannte Vertragsstaaten:
**DE FR IT**

(30) Priorität: **14.01.2000 DE 10001395**

(43) Veröffentlichungstag der Anmeldung:
**09.10.2002 Patentblatt 2002/41**

(73) Patentinhaber: **Infineon Technologies AG**
**81669 München (DE)**

(72) Erfinder: **VON WENDORFF, Wilhard**
**81241 München (DE)**

(74) Vertreter: **Repkow, Ines, Dr. Dipl.-Ing. et al**
**Jannig & Repkow**
**Patentanwälte**
**Klausenberg 20**
**86199 Augsburg (DE)**

(56) Entgegenhaltungen:
**EP-A- 0 432 764**
**EP-A- 0 820 152**
**DE-A- 19 939 567**
**US-A- 4 773 072**
**US-A- 5 862 502**

- **GRANSTROM K ET AL: "UNEQUAL ERROR PROTECTION CODES" PROCEEDINGS OF THE EUROPEAN CONFERENCE ON ELECTROTECHNICS. (EUROCON),US,NEW YORK, IEEE, Bd. CONF. 8, 13. Juni 1988 (1988-06-13), Seiten 174-176, XP000012939**
- **PATENT ABSTRACTS OF JAPAN vol. 015, no. 004 (E-1020), 8. Januar 1991 (1991-01-08) & JP 02 260934 A (NIPPONDENSO CO LTD), 23. Oktober 1990 (1990-10-23)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft ein Codierverfahren zur Codierung von Aktoren-Steuerbefehlen sowie eine Aktorensteuereinheit zur Steuerung von Aktoren bei gegenüber Datenübertragungsfehlern empfindlichen Systemen, insbesondere einem Antiblockiersystem. Ein Verfahren der eingang genannten Art ist. z.B. aus DE 19939567 bekannt.

Es gibt verschiedene Systeme, die gegenüber Datenübertragungsfehlern besonders empfindlich sind und bei denen es zu schwerwiegenden Folgen bei einer fehlerhaften Datenübertragungkommen kann. Ein Beispiel für ein derartiges empfindliches System ist ein Antiblockiersystem für ein Fahrzeug. Ein Antiblockiersystem weist in der Regel Sensoren, ein elektronisches Steuergerät sowie Magnetventile oder Drucksteuerventile auf. Die Magnetventile stellen die Aktoren des Antiblokkiersystems dar. Das elektronische Steuergerät des Antiblokkiersystems besteht aus einem Eingangsverstärker, der die Impulse der Sensoren aufbereitet, einer Computereinheit zur Berechnung der Regelsignale sowie eine Leistungsendstufe, die die Magnetventile im Hydroaggregat ansteuert. Die Ansteuerung der Aktoren bzw. Ventile erfolgt über Steuerleitungen in einem Steuerbus. Hierzu werden von dem elektronischen Steuergerät Steuerbefehle an die Magnetventile zum Schließen oder Öffnen hydraulischer Bremskreise abgegeben. Um Übertragungsfehler zu vermeiden, die bei derartigen empfindlichen Systemen zu schwerwiegenden Unfällen führen können, werden dabei die Steuerbefehle codiert und mit Redundanz versehen, um Übertragungsfehler, die beispielsweise aufgrund elektromagnetischer Einstreuung hervorgerufen werden, auf der Seite der Magnetventile erkennen zu können. Die Aktoren bzw. Magnetventile erhalten dabei pulsweiten-modulierte Steuersignale. Damit die elektromagnetische Verträglichkeit aufgrund der pulsweiten-modulierten Signale nicht herabgesetzt wird, erfolgt die Pulsweitenmodulation der Steuersignale in der Nähe der Aktoren durch eine dezentrale Aktorensteuereinheit, die mit der zentralen Systemsteuereinrichtung bzw. dem Steuergerät über einen seriellen Bus verbunden ist. Die zentrale Systemsteuereinrichtung gibt Steuerbefehls-Codeworte über den seriellen Bus an die Aktorensteuereinheit zur Steuerung der Aktoren ab. Die Aktorensteuereinheit generiert dann die pulsweiten-modulierten Steuerbefehlssignale zur Ansteuerung der Magnetventile.

Da der serielle Bus zwischen der zentralen Systemsteuereinrichtung und den Aktorensteuereinheiten jedoch nur über eine begrenzte Übertragungsbandbreite verfügt, können die Steuerbefehls-Codeworte nicht mit einer beliebig hohen Redundanz zur Erhöhung der Datensicherheit codiert werden. Der Nachteil der bisher bekannten Codierverfahren zur Codierung von Steuerbefehlen für Aktoren besteht darin, dass alle Steuerbefehle unabhängig von deren Gefährdungsgrad für das Gesamtsystem mit der gleichen Redundanz codiert werden. Jedoch wirkt sich die fehlerhafte Datenübertragung von Steuerbefehlen unterschiedlich auf das Gesamtsystem aus. In einem ABS-System für ein Fahrzeug mit vier Rädern werden pro Rad ein Einlaßventil und ein Auslaßventil und somit insgesamt acht Ventile angesteuert. Je weniger Räder aufgrund der Ventilstellung eine normale Bremsfunktion ausüben, desto höher ist der Gefährdungsgrad bei einem fehlerhaft interpretierten weiteren Steuerbefehl zur Ansteuerung der Ventile, und desto höher muß auch die Datensicherheit sein. Bei den bisherigen Codierverfahren werden derartige kritische Systemzustände bei der Codierung weiterer Steuerbefehle nicht berücksichtigt.

Es ist daher die Aufgabe der vorliegenden Erfindung, ein Codierverfahren zur Codierung von Aktoren-Steuerbefehlen und eine Aktorensteuereinheit zur Steuerung von Aktoren in einem gegenüber Datenübertragungsfehlern empfindlichen System zu schaffen, das eine erhöhte Sicherheit bei Steuerbefehlen gewährleistet, die für die Sicherheit des Systems besonders kritisch sind.

Diese Aufgabe wird erfindungsgemäß durch ein Codierverfahren mit den im Patentanspruch 1 angegebenen Merkmalen sowie durch eine Aktorensteuereinheit mit den im Patentanspruch 14 angegebenen Merkmalen gelöst.

Die Erfindung schafft ein Codierverfahren zur Codierung von Steuerbefehlen für Aktoren in einem gegenüber Datenübertragungsfehlern empfindlichen System, bei dem

ein Gefährdungsgrad eines aktuellen Sendesteuerbefehls für das Gesamtsystem durch eine Systemsteuereinrichtung bestimmt wird,

der aktuelle Sendesteuerbefehl zu einem Steuerbefehls-Codewort durch die Systemsteuereinrichtung codiert wird, wobei die codierte Redundanz des Steuerbefehls-Codewortes von dem Gefährdungsgrad für das System abhängt,

das Steuerbefehls-Codewort von der Systemsteuereinrichtung zu einer Aktorensteuereinheit übertragen wird,

das übertragene Steuerbefehls-Codewort durch die Aktorensteuereinheit zu einem Empfangssteuerbefehl decodiert wird,

der Empfangssteuerbefehl mittels der eincodierten Redundanz auf Übertragungsfehler überprüft wird, und

mindestens ein Aktor zur Durchführung des Empfangssteuerbefehls angesteuert wird, wenn kein Übertragungsfehler festgestellt wird.

Vorzugsweise speichert die Systemsteuereinrichtung alle an die Aktorensteuereinheit bisher übertragenen Sendesteuerbefehle ab.

Dies bietet den besonderen Vorteil, dass die zentrale Systemsteuereinrichtung ständig den aktuellen Zustand der mit ihr verbundenen Aktorensteuereinheiten verfolgen kann.

Bei einer weiteren bevorzugten Ausführungsform wird der aktuelle Sendesteuerbefehl und die früheren Sendesteuerbefehle durch die zentrale Systemsteuereinrichtung komprimiert.

Der komprimierte aktuelle Steuerbefehl und die komprimierten früheren Steuerbefehle für die Aktorensteuereinheit werden vorzugsweise durch die Systemsteuereinrichtung zu dem Steuerbefehls-Codewort codiert.

Von der Aktorensteuereinheit wird bei einer bevorzugten Ausführungsform der aktuell empfangene und decodierte Empfangssteuerbefehl in einem Speicher der Aktorensteuereinheit abgespeichert.

Der aktuelle Empfangssteuerbefehl und die bisher empfangenen Empfangssteuerbefehle werden vorzugsweise komprimiert.

Bei einer weiteren bevorzugten Ausführungsform des erfindungsgemäßen Codierverfahrens wird der komprimierte aktuelle Sendesteuerbefehl und die komprimierten früheren Sendesteuerbefehle, die durch die Systemsteuereinrichtung an die Aktorensteuereinheit übertragen werden, mit dem komprimierten aktuellen Empfangssteuerbefehl und den abgespeicherten früheren Empfangssteuerbefehlen durch eine in der Aktorensteuereinheit vorgesehene Vergleichsschaltung verglichen, die die Steuersignale an die Aktoren zur Durchführung des aktuellen Empfangssteuerbefehls abgibt, wenn diese komprimierten Steuerbefehle gleich sind.

Die an die Aktoren abgegebenen Steuersignale sind vorzugsweise pulsweiten-moduliert.

Bei einer weiteren bevorzugten Ausführungsform werden die Steuerbefehls-Codeworte über einen seriellen Bus an die Aktorensteuereinheit übertragen.

Bei einer weiteren bevorzugten Ausführungsform des erfindungsgemäßen Codierverfahrens werden die empfangenen, seriell übertragenen Steuerbefehls-Codeworte durch einen in der Aktorensteuereinheit enthaltenen Seriell-/Parallelwandler in parallele Steuerbefehlsdaten umgewandelt.

Die parallel gewandelten Steuerbefehlsdaten werden vorzugsweise durch eine Decodiereinrichtung der Aktorensteuereinheit decodiert.

Die Steuerbefehle umfassen vorzugsweise Aktoren-Einstellbefehle, Aktoren-Statusabfragebefehle und Aktoren-Konfigurationsbefehle.

Bei einer weiteren bevorzugten Ausführungsform wird die Redundanz eines übertragenen Steuerbefehls-Codewortes mit zunehmendem Gefährdungsgrad des Steuerbefehls für das System erhöht.

Bei einer besonders bevorzugten Ausführungsform des erfindungsgemäßen Verfahrens wird der Steuerbefehl mittels eines Fehlerkorrekturcodes codiert.

Bei einer weiteren bevorzugten Ausführungsform werden durch das erfindungsgemäße Codierverfahren Steuerbefehle für Aktoren in einem Antiblockiersystem codiert.

Die Aktoren sind dabei vorzugsweise steuerbare Ventile.

Bei einer weiteren bevorzugten Ausführungsform hängt der Gefährdungsgrad für das gegenüber Datenübertragungsfehlern empfindliche System von der Schaltzustandskombination der verschiedenen Aktoren ab und wird tabellenförmig in einem Speicher der Systemsteuereinrichtung abgespeichert.

Die Erfindung schafft ferner eine Aktorensteuereinheit zur Steuerung von Aktoren in einem gegenüber Datenübertragungsfehlern empfindlichen System mit:

(a) einer Sende- und Empfangseinrichtung zum Anschluß der Aktorensteuereinheit an einen seriellen Bus;
(b) einer Decodiereinrichtung zum Decodieren von Steuerbefehls-Codeworten, die über den Serienbus übertragen werden, wobei die Redundanz der Steuerbefehls-Codeworte von dem Gefährdungsgrad des codierten Steuerbefehls für das System abhängt;
(c) einem Speicher zum Abspeichern der decodierten Steuerbefehle;
(d) einer Datenkompressionseinrichtung zum Komprimieren der Steuerbefehle, und mit
(e) einer Datenvergleichsschaltung zur Überprüfung der an die Aktorensteuereinheit von der Systemsteuereinrichtung übertragenen Folge von Steuerbefehlen.

Im weiteren werden vorteilhafte Ausgestaltungen des erfindungsgemäßen Codierverfahrens zur Codierung von Steuerbefehlen der Aktoren in einem gegenüber Datenübertragungsfehlern empfindlichen System und der erfindungsgemäßen Aktorensteuereinheit unter Bezugnahme auf die beigefügten Zeichnungen zur Erläuterung erfindungswesentlicher Merkmale beschrieben.

Es zeigen:

Fig. 1 ein schematisches Blockschaltbild einer mit einer Systemsteuereinrichtung über einen seriellen Bus verbundenen Aktorensteuereinheit gemäß der Erfindung;

Fig. 2 ein Ablaufdiagramm des erfindungsgemäßen Codierverfahrens zur Codierung von Steuerbefehlen für Aktoren;

Fig. 3 ein detailliertes Blockschaltbild einer bevorzugten Ausführungsform der erfindungsgemäßen Aktorensteuereinheit.

Fig. 4 Beispiele für Codierung von Steuerbefehlen zur Ansteuerung von Einlass- und Auslassventilen bei einem ABS-System

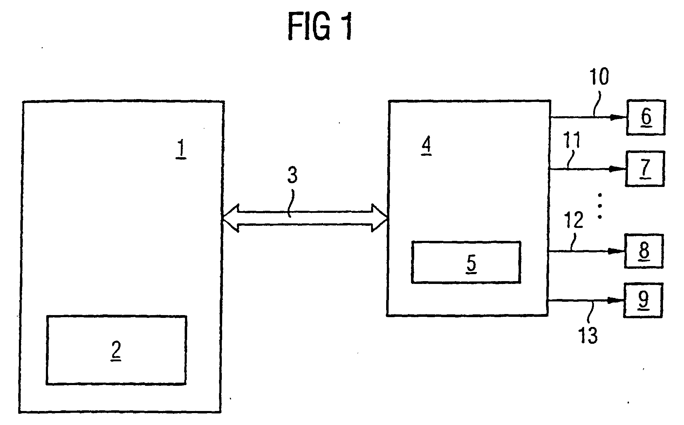

Fig. 1 zeigt schematisch eine Schaltung mit einer zentralen Systemsteuereinrichtung 1 eines Datenübertragungssystems. Die Systemsteuereinrichtung 1 enthält einen internen Speicher 2, beispielsweise einen RAM-Speicher. Die zentrale Systemsteuereinrichtung 1 ist über einen seriellen Bus 3 mit einer dezentralen Aktorensteuereinheit 4 zur Ansteuerung von Aktoren verbunden. Die Aktorensteuereinheit 4 enthält ebenfalls einen internen Speicher 5. Bei einer bevorzugten Ausführungsform besteht der interne Speicher 5 aus einer Vielzahl von Registerbauelementen. Die dezentrale Aktorensteuereinheit 4 steuert eine bestimmte Gruppe von Aktoren innerhalb des Gesamtsystems, beispielsweise die Magnetsteuerventile eines Antiblokkiersystems für ein Fahrzeug. Die Aktoren 6, 7, 8, 9 werden über Steuerleitungen 10, 11, 12, 13 durch die Aktorensteuereinheit 4 angesteuert. Dabei werden die Steuersignale vorzugsweise pulsweiten-moduliert übertragen.

Der serielle Bus 3 besteht bei einer bevorzugten Ausführungsform aus vier Leitungen, nämlich aus einer ersten seriellen Datenleitung zur Übertragung von Datenleitungen von der Systemsteuereinrichtung 1 zu der Aktorensteuereinheit 4, einer zweiten seriellen Datenübertragungsleitung zur Übertragung von Daten von der Aktorensteuereinheit 4 zu der Systemsteuereinrichtung 1 einer Taktsignalleitung sowie einer Auswahlsteuerleitung 4 zur Auswahl bzw. Selektion einer Aktorensteuereinheit.

Bei dem in Fig. 1 gezeigten Beispiel wird lediglich eine dezentrale Aktorensteuereinheit 4 dargestellt. Bei weiteren, nicht gezeigten Ausführungsformen ist die zentrale Systemsteuereinrichtung 1 über den seriellen Bus 3 mit einer Vielzahl von dezentralen Aktoren-Steuereinrichtungen 4 verbunden. Da die eigentlichen Steuerbefehlssignale zur Ansteuerung der Aktoren 6, 7, 8, 9 in der dezentralen Aktorensteuereinheit 4 pulsweiten-moduliert werden, ist die elektromagnetische Verträglichkeit für Daten auf dem seriellen Bus hoch, d.h. die Verfälschung der übertragenen Befehlsdaten aufgrund von elektromagnetischer Abstrahlung von einer Datenleitung zu einer anderen Datenleitung wird weitestgehend vermieden.

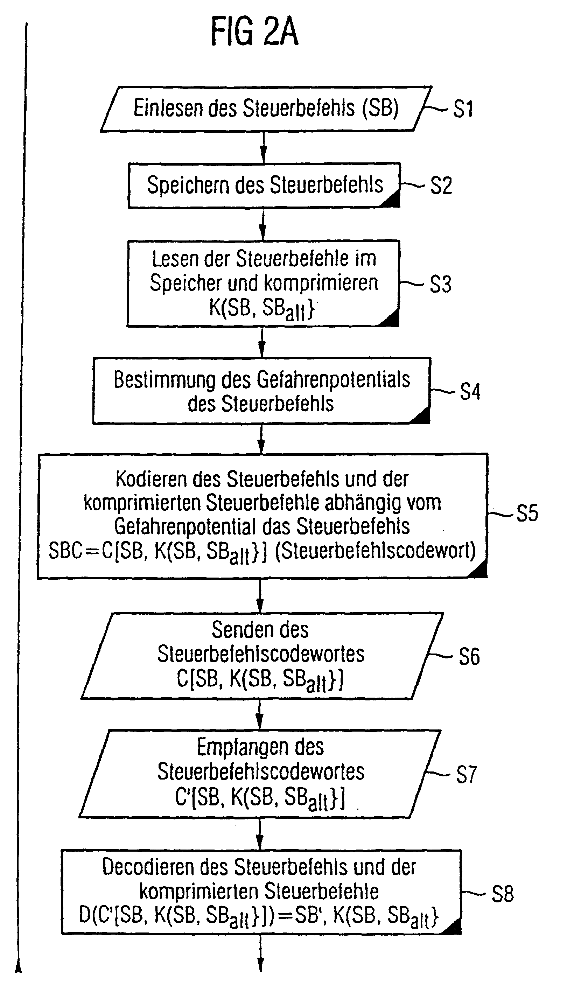

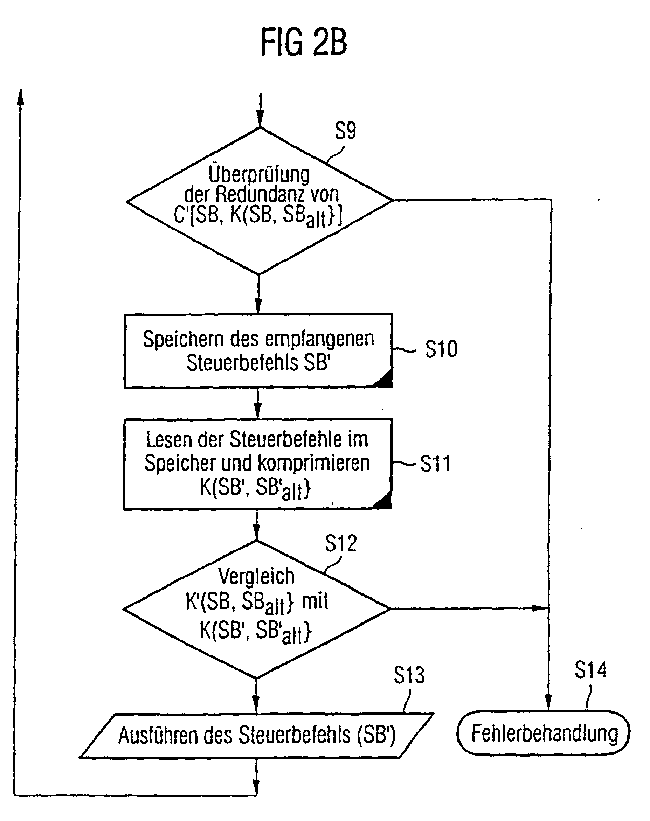

Fig. 2 zeigt ein Ablaufdiagramm des erfindungsgemäßen Codierverfahrens zur Codierung von Steuerbefehlen für Aktoren in einem gegenüber Datenübertragungsfehlern empfindlichen System.

In einem Schritt S1 liest die Systemsteuereinrichtung 1 einen auszuführenden Steuerbefehl ein.

Der auszuführende Steuerbefehl SB wird in dem internen Speicher 2 im Schritt S2 abgespeichert.

In einem Schritt S3 werden anschließend alle bisher an die bestimmte Aktorensteuereinheit 4 bereits früher übertragenen "alten" Steuerbefehle aus $SB_{alt}$ dem Speicher 2 ausgelesen und zusammen mit dem aktuell an die Aktorensteuereinheit 4 zu übertragenden Steuerbefehl SB komprimiert zu $K(SB,SB_{alt})$

Im Schritt S4 wird anschließend durch die zentrale Steuereinrichtung 1 der Gefährdungsgrad des aktuellen, an die Aktorensteuereinheit 4 zu übertragenden Steuerbefehls für das Gesamtsystem bestimmt. Je nachteiliger die Auswirkung einer fehlerhaften Übertragung des Steuerbefehls an die Aktorensteuereinheit 4 für das Gesamtsystem ist, desto höher ist der Gefährdungsgrad des Steuerbefehls. Führt beispielsweise eine fehlerhafte Übertragung des Steuerbefehls und somit eine fehlerhafte bzw. nicht erfolgende Ausführung des Steuerbefehls zu einem Unfall des Gesamtsystems, besitzt der Steuerbefehl somit einen sehr hohen Gefährdungsgrad, und seine fehlerfreie Datenübertragung muss auf jeden Fall gesichert sein.

Im Schritt S5 wird der aktuelle Steuerbefehl SB und die ausgelesenen, bisher an die Aktorensteuereinheit 4 übertragenen Steuerbefehle in komprimierter Form abhängig von dem ermittelten Gefährdungsgrad des Steuerbefehls für das Gesamtsystem zu einem Steuerbefehls-Codewort SBC codiert.

$$SBC = C[SB,K\{SB,SB_{alt}\}]$$

Im Schritt S6 wird anschließend das Steuerbefehls-Codewort SBC von der Systemsteuereinrichtung 1 über den seriellen Bus an die Aktorensteuereinheit 4 gesendet.

Im Schritt S7 empfängt die Aktorensteuereinheit 4 das übertragene Steuerbefehls-Codewort SBC.

Im Schritt S8 wird das empfangene Steuerbefehls-Codewort SBC und die komprimierten, übertragenen bisherigen Steuerbefehle decodiert.

$$D(C'[SB,K\{SB,SB_{alt}\}]) = SB',K'\{SB,SB_{alt}\}$$

Nachfolgend wird im Schritt S9 der empfangene Steuerbefehl und die decodierten, komprimierten, bisher an die Aktorensteuereinheit 4 übertragenen alten Steuerbefehle auf Übertragungsfehler mittels der übertragenen Redundanzdaten überprüft.

Falls im Schritt S9 durch die Aktorensteuereinheit 4 ein Übertragungsfehler erfasst wird, erfolgt im Schritt S14 eine Fehlerbehandlung.

Falls im Schritt S9 kein Übertragungsfehler ermittelt wird, wird der empfangene aktuelle Steuerbefehl SB im Schritt S10 in dem internen Speicher 5 der Aktorensteuereinheit 4 gespeichert.

Im Schritt S11 werden die in dem Speicher 5 abgespeicherten Steuerbefehle, d.h. der aktuell abgespeicherte Steuerbefehl SB' sowie die bisher empfangenen Steuerbefehle $SB'_{alt}$ ausgelesen und anschließend komprimiert.

Im Schritt S12 wird die in dem decodierten Steuerbefehls-Codewort enthaltene Information bezüglich der bisher an die Aktorensteuereinheit 4 übertragenen Steuerbefehle $K'\{SH,SB_{alt}\}$ mit den im Schritt S11 ausgelesenen und komprimierten Steuerbefehlen verglichen. Ergibt der Vergleich in Schritt S12 eine Übereinstimmung, wird der aktuell empfangene Steuerbefehl im Schritt S13 ausgeführt, indem die Aktorensteuereinheit 4 über die Steuersignalleitung 10, 11, 12, 13 Steuersignale an die Aktoren 6, 7, 8, 9 abgibt.

Falls umgekehrt im Schritt S12 durch den Vergleich keine Übereinstimmung festgestellt wird, erfolgt im Schritt S14 die Fehlerbehandlung.

Da die Systemsteuereinrichtung 1 die Folge von Sendesteuerbefehlen, die sie bisher an die Aktorensteuereinrichtung 4 abgegeben hat, abspeichert und bei jedem neuen Steuerbefehl an diese Aktorensteuereinheit 4 komprimiert und codiert als Information innerhalb des Steuerbefehl-Codeworts abgibt, kann die Aktorensteuereinheit 4 durch den Vergleich selbst überprüfen, ob sie sich in dem gewünschten Zustand befindet. Falls die in dem internen Speicher 2 der Systemsteuereinrichtung 1 abgespeicherte Folge von Steuerbefehlen von der in dem internen Speicher 5 der Aktorensteuereinheit 4 abgespeicherten Folge abweicht, erfolgt im Schritt S14 die Fehlerbehandlung. Die Fehlerbehandlung besteht beispielsweise darin, dass die Aktorensteuereinheit 4 den Fehler bzw. die Abweichung an die zentrale Systemsteuereinrichtung 1 über den seriellen Bus 3 meldet, woraufhin die zentrale Systemsteuereinrichtung 1 einen Steuerbefehl an die dezentrale Aktorensteuereinrichtung 4 abgibt, um diese und gegebenenfalls weitere Aktorensteuereinheiten 4 in einen definierten stabilen Zustand zu versetzen. Jedes übertragene Steuerbefehls-Codewort SBC enthält nicht nur Information über den aktuell auszuführenden Steuerbefehl, sondern auch Informationen über die bisher durch die Aktorensteuereinheit 4 ausgeführte Steuerbefehlsfolge. Die zentrale Steuereinrichtung 1 enthält somit in ihrem internen Speicher 2 stets eine Zustandskopie aller mit ihr über den seriellen Bus 3 verbundenen dezentralen Aktorensteuereinheiten 4, so dass der Zustand aller dezentralen Aktorensteuereinheiten 4 stets überwachbar ist, ohne dass stets Rückmeldungen von den Aktorensteuereinheiten 4 zu der zentralen Systemsteuereinrichtung 1 erfolgen müssen.

Das Komprimieren der Information über die Historie bzw. die bisherige Folge von übertragenen Steuerbefehlen gewährleistet, dass die Übertragungsbandbreite des seriellen Busses 3 optimal ausgenutzt wird.

Die an die Aktorensteuereinheit 4 übertragenen Steuerbefehle umfassen Aktoren-Einstellbefehle, Aktoren-Statusabfragebefehle sowie Aktoren-Konfigurationsbefehle.

Die Steuerbefehle werden durch die zentrale Steuereinrichtung 1 in einem Codierer mittels eines Fehlerkorrekturcodes ECC (Error Correction Code) oder CRC (Cyclic Redundancy Code) codiert. Durch die Codierung wird dem Steuerbefehl eine Datenredundanz verliehen, wobei die Hamming-Distanz der übertragenen Steuerbefehls-Codeworte von dem Gefährdungsgrad des zu übertragenden Steuerbefehls für das Gesamtsystem erhöht wird. Anhand der in dem internen Speicher 2 abgespeicherten Kopie der bereits an die verschiedenen Aktorensteuereinheiten 4 übertragenen Steuerbefehle, die den Gesamtzustand des Systems darstellen, erkennt die zentrale Steuereinrichtung 1, wie sich der neuartige Befehl auf das System auswirkt und ob eine fehlerhafte Datenübertragung des Steuerbefehls zu einem kritischen Systemzustand führen kann. Je höher der Gefährdungsgrad bzw. das Gefahrenpotential des zu übertragenen Steuerbefehls für das Gesamtsystem ist, desto höher wird die dem Steuerbefehls-Codewort SBC verliehene Datenredundanz eingestellt. Ein Steuerbefehl, der mit hoher Sicherheit wegen Datenübertragungsfehler an die Aktorensteuereinheit 4 übertragen werden muss, erhält durch die in der zentralen Steuereinrichtung enthaltene Codiereinrichtung eine höhere Datenredundanz als ein Steuerbefehl, dessen fehlerhafte Datenübertragung das Gesamtsystem in geringerem Ausmaß gefährdet.

Vorzugsweise enthält die zentrale Steuereinrichtung 1 eine Tabelle, bei dem jedem Steuerbefehl entsprechend einer Gefährdungsklasse für das Gesamtsystem ein zugeordnetes codiertes Steuerbefehls-Codewort SBC zugeordnet abgespeichert ist. Da die kritischen Steuerbefehle stets zu einer höheren Redundanz codiert werden, ist die Wahrscheinlichkeit, dass sie fehlerhaft an die Aktorensteuereinheit 4 übertragen werden, sehr gering, wodurch die Sicherheit des Gesamtsystems erhöht wird.

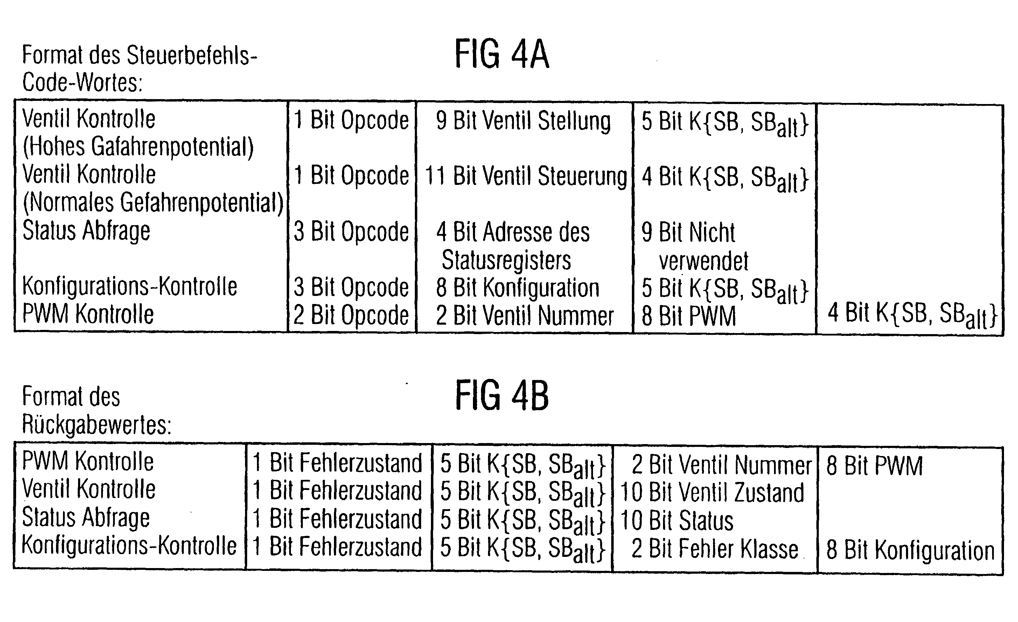

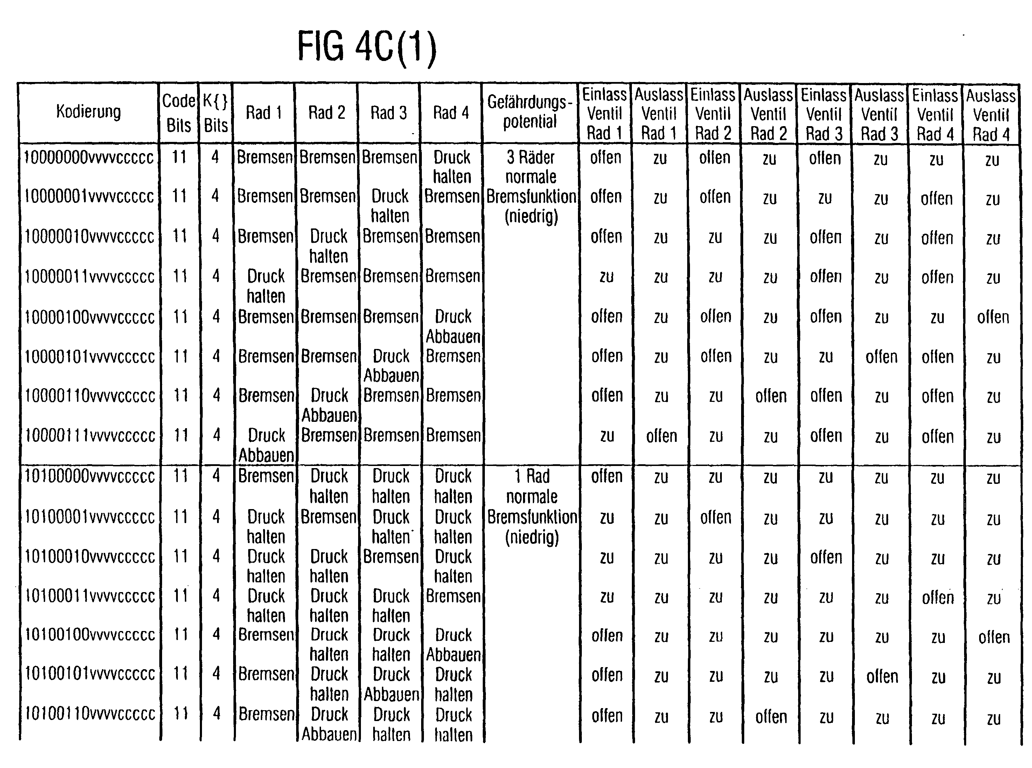

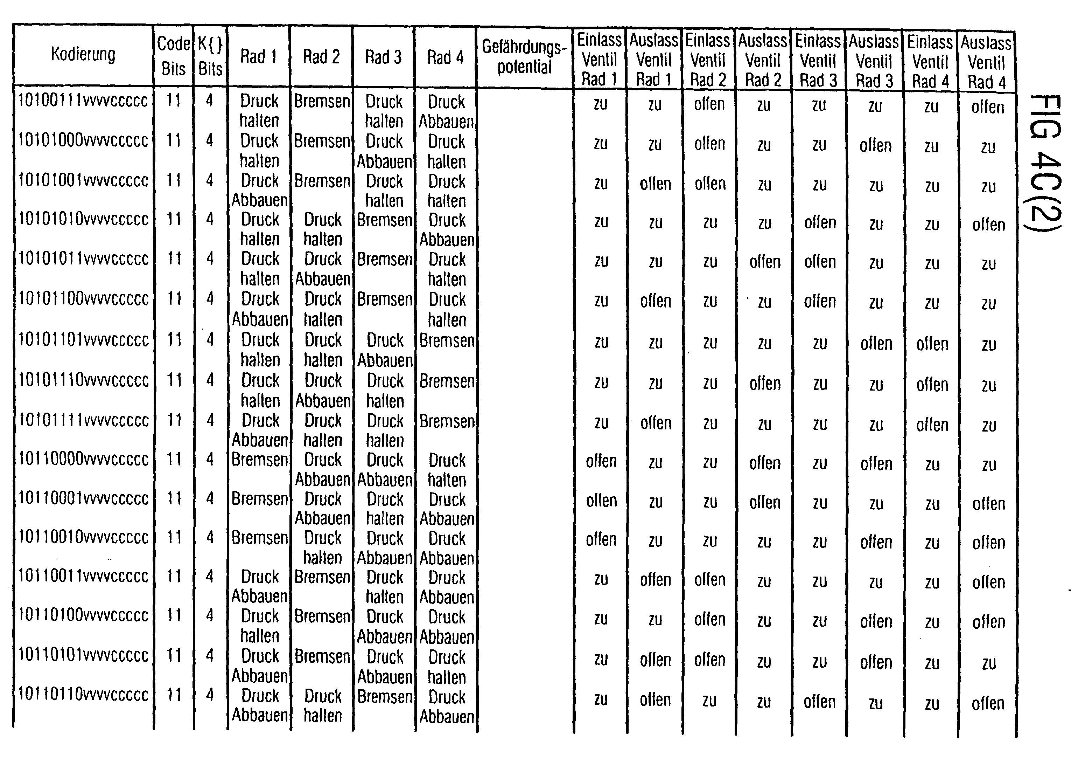

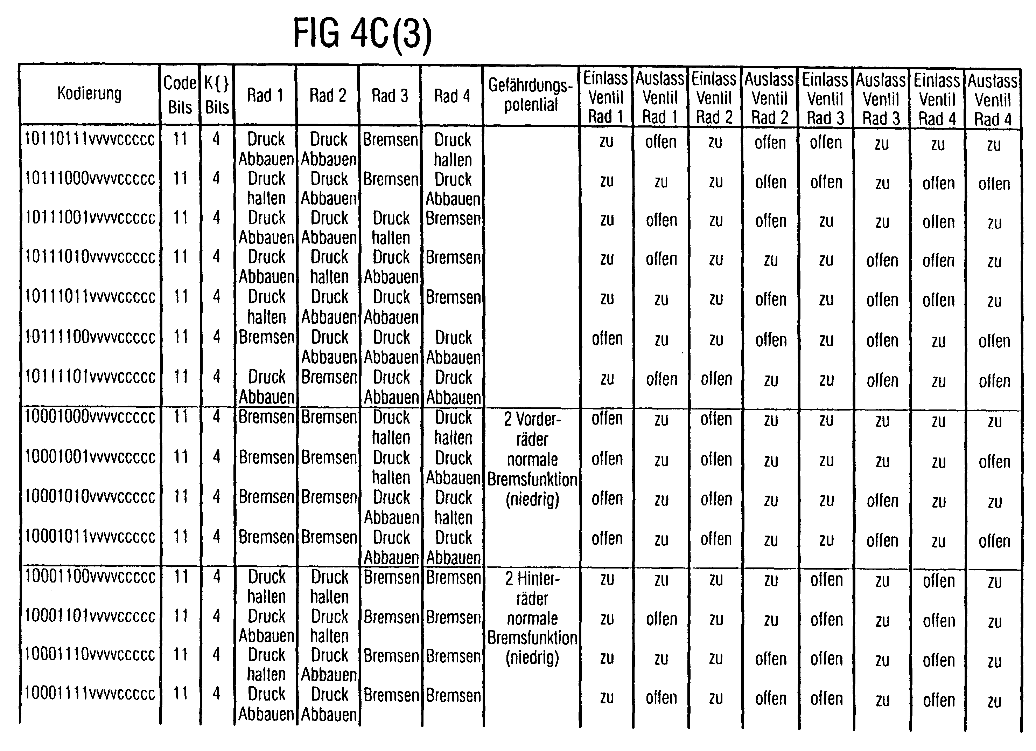

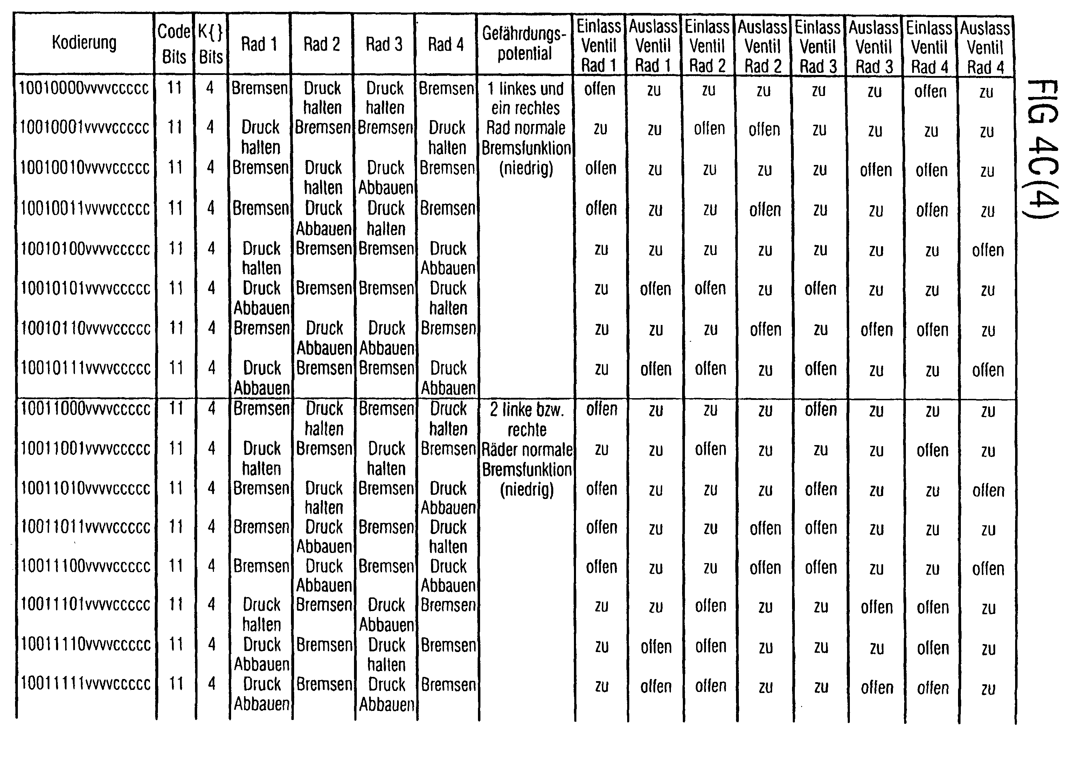

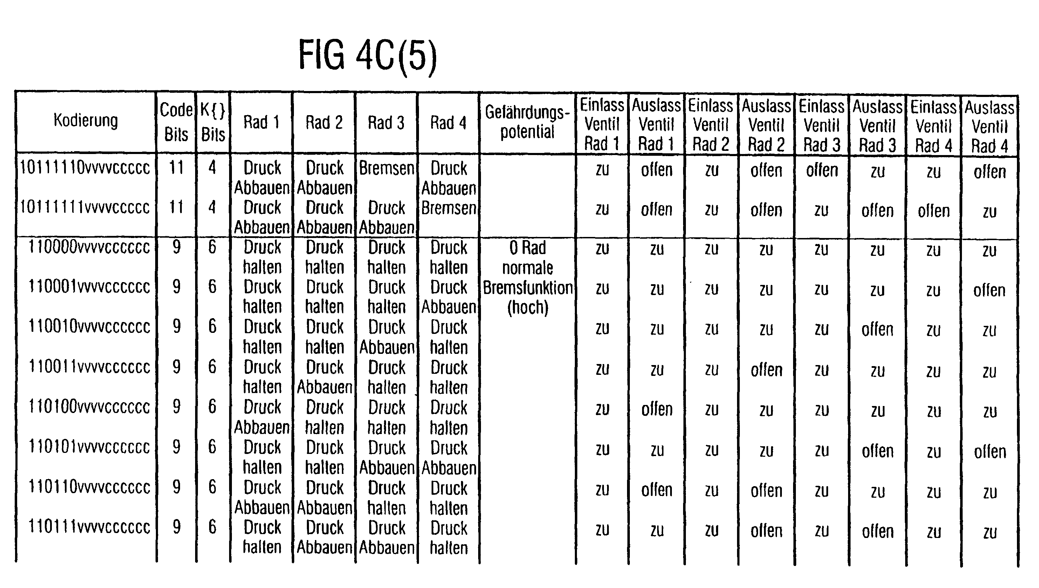

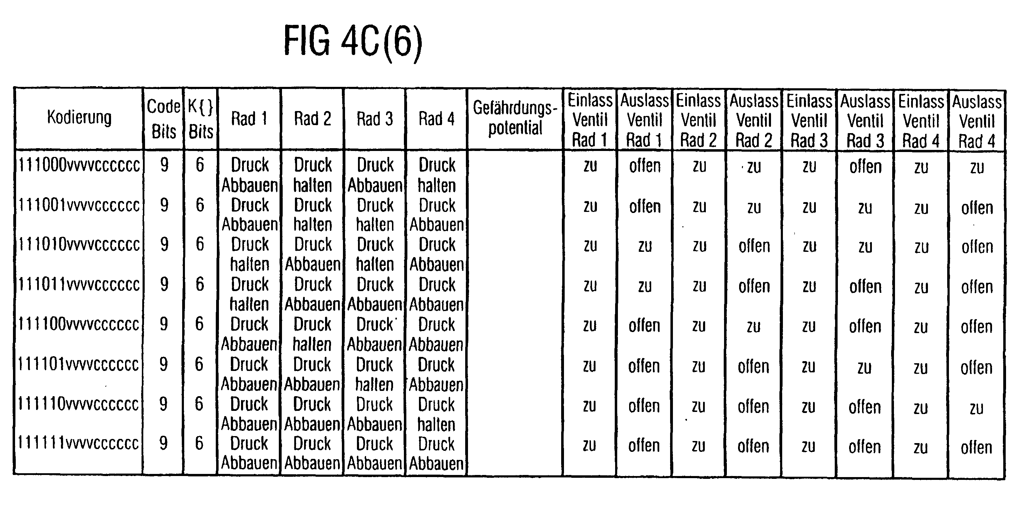

Figur 4 zeigt Tabellen für die Codierung von Steuerbefehlen zur Ansteuerung von Einlass- und Auslassventilen bei einem ABS-Kraftfahrzeugsystem.

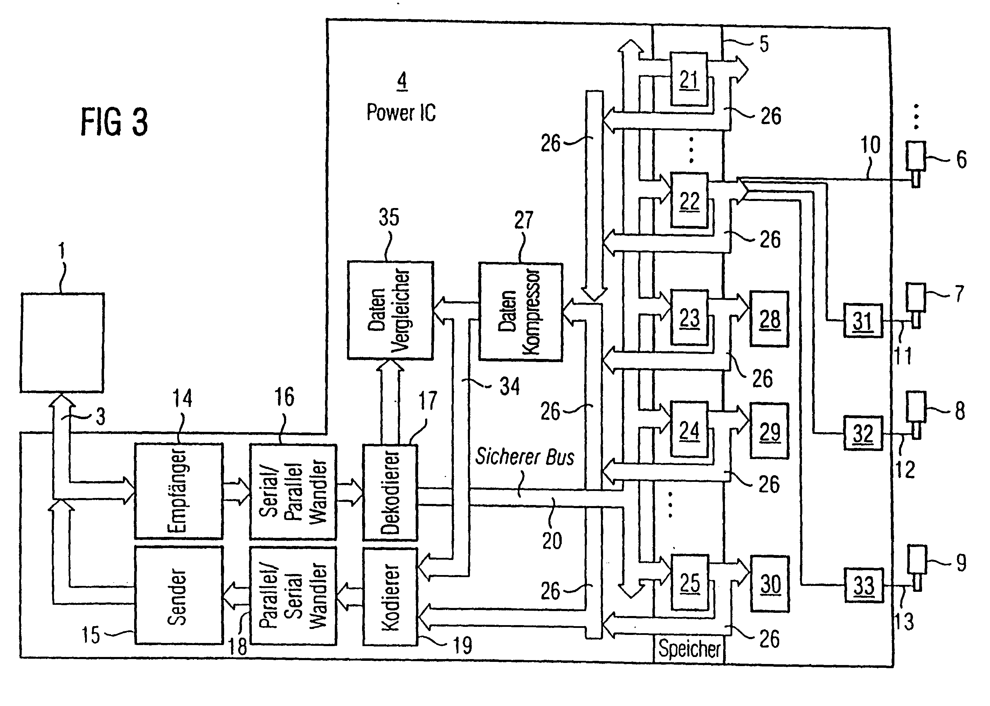

Fig. 3 zeigt eine bevorzugte Ausführungsform der erfindungsgemäßen Aktorensteuereinheit 4. Der serielle Bus 3 ist mit einer seriellen Datenempfangseinrichtung 14 und einer seriellen Sendeeinrichtung 15 verbunden. Die serielle Datenempfangseinrichtung erhält die über den seriellen Bus 3 zugeführten Empfangsdaten und gibt sie an einen Seriell-/Parallelwandler 16 ab, der den seriellen Datenstrom parallel wandelt und einer Decodiereinrichtung 17 zuführt. Umgekehrt erhält die serielle Sendeeinrichtung 15 von einem Parallel-/Seriellwandler 18 serielle Daten. Der Parallel-/Seriellwandler 18 erhält die Sendedaten von einer internen Codiereinrichtung 19 der Aktorensteuereinrichtung 4.

Der Decodierer 17 ist über einen internen Bus 20 mit dem Dateneingang verschiedener Register 21, 22, 23, 24, 25 verbunden. Die Datenausgänge der Register 21, 22, 23, 24, 25 sind über einen internen Datenbus 26 mit dem Eingang der Codiereinrichtung 19 und mit dem Eingang einer Datenkompressionseinrichtung 27 verbunden. Die Speicherregister 21-25 bilden zusammen den internen Speicher 5 der Aktorensteuereinrichtung 4. Die Datenausgänge der Speicherregister 21-15 sind entweder direkt mit Aktoren über Steuersignalleitungen verbunden oder sind an Pulsweiten-Modulationseinrichtungen 28, 29, 30 angeschlossen. Den Pulsweiten-Modulationseinrichtungen 28, 29, 30 sind bei dem in Fig. 3 gezeigten Beispiel Multiplexer 31, 32, 33 nachgeschaltet zum Umschalten der Ausgangssteuersignale.

Die Datenkompressionseinrichtung 27 ist ausgangsseitig über einen internen Bus 34 an einen zweiten Eingang der Codiereinrichtung 19 und an einen Eingang einer Datenvergleichsschaltung 35 angeschlossen. Die Datenvergleichsschaltung 35 ist eingangsseitig einerseits mit der Datenkompressionsschaltung 27 und ausgangsseitig mit der Decodiereinrichtung 17 verbunden.

Die Datenempfangseinrichtung 14 empfängt im Schritt S7 des in Fig. 2 dargestellten erfindungsgemäßen Verfahrens die übertragenen Steuerbefehls-Codeworte SBC. Die seriell empfangenen Steuerbefehls-Codeworte werden durch den Seriell-/Parallelwandler 16 in ein paralleles Datenformat umgewandelt und der Decodiereinrichtung 17 zugeführt, die im Schritt S8 das Steuerbefehls-Codewort decodiert. Der empfangene Steuerbefehl SB wird im Schritt S10 in den Speicherregistern 21-25 gespeichert, und die bisher abgespeicherten Steuerbefehle werden über den internen Bus 26 ausgelesen und durch die Datenkompressionsschaltung 27 komprimiert. Die Datenvergleichsschaltung 35 vergleicht dann die in dem decodierten Steuerbefehls-Codewort enthaltene komprimierte Information über die bisher an die Aktorensteuereinheit 4 übertragenen Steuerbefehle mit den durch die Datenkompressionseinschaltung 27 komprimierten, aus den Speicherregistern 21-25 ausgelesenen Steuerbefehlen. Falls die Datenvergleichsschaltung 35 im Schritt S12 eine Übereinstimmung feststellt, werden die Steuerbefehle über die Steuerleitungen 10-13 zur Ausführung des Steuerbefehls an die Aktoren 6-9 abgegeben.

Über den Codierer 19, den Parallel-/Seriellwandler 18 sowie die Sendeeinrichtung 15 kann die Aktorensteuereinheit 4 Rückgabe-Codeworte über den seriellen Bus 3 zurück an die Systemsteuereinrichtung 1 abgeben. Solche Rückgabe-Kontrollcodeworte dienen der Pulsweiten-Modulationskontrolle der Aktorenzustandskontrolle, der Statusabfrage sowie der Konfigurationskontrolle der Aktorensteuereinheit 4.

Bezugszeichenliste

| | |
|---|---|
| 1 | Systemsteuereinrichtung |
| 2 | interner Speicher |
| 3 | serieller Bus |
| 4 | Aktoren-Steuereinheit |
| 5 | interner Speicher |
| 6, 7, 8, 9 | Aktoren |
| 10, 11, 12, 13 | Steuerleitungen |
| 14 | Empfangseinrichtung |
| 15 | Sendeeinrichtung |
| 16 | Seriell-/Parallelwandler |
| 17 | Decodierer |
| 18 | Parallel-/Seriellwandler |
| 19 | Codierer |
| 20 | interner Bus |
| 21, 22, 23, 24, 25 | Speicherregister |
| 26 | interner Bus |
| 27 | Datenkompressionseinrichtung |
| 28, 29, 30 | Pulsweiten-Modulationseinrichtung |
| 31, 32, 33 | Multiplexer |
| 34 | interner Bus |
| 35 | Datenvergleichsschaltung |

**Patentansprüche**

1. Codierverfahren zur Codierung von Steuerbefehlen für Aktoren mit einem gegenüber Datenübertragungsfehlern empfindlichen System mit den folgenden Schritten:

    (a) Bestimmen eines Gefährdungsgrades eines aktuellen Sendesteuerbefehls (SB) für das System durch eine Systemsteuereinrichtung (1);

    (b) Codieren des aktuellen Sendesteuerbefehls (SB) zu einem Steuerbefehls-Codewort (SBC) durch die Systemsteuereinrichtung (1), wobei die Redundanz des Steuerbefehls-Codewortes (SBC) von dem Gefährdungsgrad des aktuellen Sendesteuerbefehls (SB) für das System abhängt, und zwar derart, dass die Redundanz des Steuerbefehls-Codewortes (SBC) umso höher ist, je nachteiliger die Auswirkung einer fehlerhaften Übertragung des aktuellen Sendesteuerbefehls (SB) für das System ist;

    (c) Übertragen des Steuerbefehls-Codewortes (SBC) von der Systemsteuereinrichtung (1) zu einer Aktorensteuereinheit (4) ;

    (d) Decodieren des übertragenen Steuerbefehls-Codewortes (SBC) durch die Aktorensteuereinheit (4) zu einem Empfangssteuerbefehl (SB');

    (e) Überprüfen des Empfangssteuerbefehls (SB') auf Übertragungsfehler;

    (f) Ansteuern von mindestens einem Aktor (6, 7, 8, 9) zur Durchführung des Empfangssteuerbefehls SB', wenn kein Übertragungsfehler festgestellt wird.

2. Verfahren nach Anspruch 1,
**dadurch gekennzeichnet,**
**dass** die Systemsteuereinrichtung (1) intern alle an die Aktorensteuereinheit (4) bisher übertragenen Sendesteuerbefehle ($SB_{alt}$) abspeichert.

3. Verfahren nach Anspruch 1 oder 2,
**dadurch gekennzeichnet,**
**dass** der aktuelle Sendesteuerbefehl (SB) und die bisher an die Aktorensteuereinheit übertragenen Sendesteuerbefehle ($SB_{alt}$) durch die Systemsteuereinrichtung (1) vor der Übertragung komprimiert werden.

4. Verfahren nach einem der vorangehenden Ansprüche,
**dadurch gekennzeichnet,**
**dass** der aktuelle Sendesteuerbefehl (SB) und die bisher über die Aktorensteuereinheit (4) übertragenen Steuerbefehle ($SB_{alt}$), die durch die Systemsteuereinrichtung (1) komprimiert werden, vor der Übertragung zu dem Steuerbefehls-Codewort (SBC) durch die Systemsteuereinrichtung (1) codiert werden.

5. Verfahren nach einem der vorangehenden Ansprüche,
**dadurch gekennzeichnet,**
**dass** die Aktorensteuereinheit (4) den empfangenen aktuellen und decodierten Empfangssteuerbefehl (SB') in einem Speicher (5) der Aktorensteuereinheit (4) speichert.

6. Verfahren nach einem der vorangehenden Ansprüche,
**dadurch gekennzeichnet,**
**dass** die bisher empfangenen und abgespeicherten Empfangssteuerbefehle in der Aktorensteuereinheit (4) durch eine Datenkompressionsschaltung (27) komprimiert werden.

7. Verfahren nach Anspruch 6,
**dadurch gekennzeichnet,**
**dass** die dekodierte komprimierte Folge von bisher an die Aktorensteuereinheit (4) übertragenen Steuerbefehle $K(SB, SB_{alt})$ mit den in dem Speicher (5) der Aktoreneinheit (4) abgespeicherten, komprimierten Steuerbefehlen $K(SB', SB'_{alt})$ durch eine Datenvergleichsschaltung (35) verglichen werden, wobei, wenn die komprimierten Steuerbefehle gleich sind, die Aktorensteuereinheit (4) Steuersignale an die Aktoren (6, 7, 8, 9) zur Durchführung des aktuellen empfangenen Steuerbefehls SB' abgibt.

8. Verfahren nach einem der vorangehenden Ansprüche,
**dadurch gekennzeichnet,**
**dass** die Steuersignale zur Ansteuerung der Aktoren (6, 7, 8, 9) pulsweiten-moduliert werden.

9. Verfahren nach einem der vorangehenden Ansprüche,
**dadurch gekennzeichnet,**
**dass** die Steuerbefehls-Codeworte (SBC) über einen seriellen Bus (3) an die Aktorensteuereinheit (4) übertragen werden.

10. Verfahren nach Anspruch 9,
**dadurch gekennzeichnet,**
**dass** die seriell übertragenen, empfangenen Steuerbefehls-Codeworte (SBC) durch einen Seriell-/Parallelwandler (16) der Aktorensteuereinheit (4) in parallele Steuerbefehlsdaten gewandelt werden.

11. Verfahren nach Anspruch 10,
**dadurch gekennzeichnet,**
**dass** die parallel gewandelten Steuerbefehlsdaten durch einen Decodierer (17) decodiert werden.

12. Verfahren nach einem der vorangehenden Ansprüche,
**dadurch gekennzeichnet,**
**dass** die Steuerbefehle Aktoren-Einstellbefehle, Aktoren-Statusabfragebefehle und Aktoren-Konfigurationsbefehle umfassen.

13. Aktorensteuereinheit zur Steuerung von Aktoren in einem gegenüber Datenübertragungsfehlern empfindlichen System mit:

(a) einer Sende- und Empfangseinrichtung (14, 15) zum Anschluß an einen seriellen Bus (3);

(b) einer Decodiereinrichtung zum Decodieren von über den seriellen Bus (3) übertragenen Steuerbefehls-Codeworten (SBC), deren eincodierte Redundanz von einem Gefährdungsgrad des codierten Steuerbefehls (SB) für das System abhängt, und zwar derart, dass die Redundanz des Steuerbefehls-Codewortes (SBC) umso höher ist, je nachteiliger die Auswirkung einer fehlerhaften Übertragung des aktuellen Steuerbefehls (SB) für das System ist;

(c) einem Speicher (5) zum Abspeichern der decodierten Steuerbefehle;

(d) einer Datenkompressionsschaltung zum Komprimieren der abgespeicherten Steuerbefehle; und mit

(e) einer Datenvergleichsschaltung (35) zum Vergleichen, ob die in dem Speicher (5) abgespeicherte Steuerbefehlsfolge mit einer in dem übertragenen Steuerbefehls-Codewort (SBC) enthaltenen Steuerbefehlsfolge übereinstimmt.

14. Aktorensteuereinheit nach Anspruch 13,
**dadurch gekennzeichnet,**
**dass** der Speicher (5) der Aktorensteuereinheit (4) aus mehreren Speicherregistern (21, 22, 23, 24, 25) zur Abgabe von Steuersignalen an zugehörige Aktoren (6, 7, 8, 9) besteht.

15. Aktorensteuereinheit nach Anspruch 13,
**dadurch gekennzeichnet,**
**dass** Pulsweiten-Modulationseinrichtungen (28, 29, 30) zur Pulsweitenmodulation der Steuersignale vorgesehen sind.

16. Aktorensteuereinheit nach einem der Ansprüche 13 bis 15,
**dadurch gekennzeichnet,**
**dass** die Sende- und Empfangseinrichtung (14, 15) eine Datenempfangseinrichtung (14) zum Empfang serieller Daten von der Systemsteuereinrichtung (1) über eine erste Datenleitung und eine Sendeeinrichtung (15) zur Abgabe von seriellen Daten an die Systemsteuereinrichtung (1) über eine zweite Datenleitung aufweist.

**17.** Aktorensteuereinheit nach Anspruch 16,
**dadurch gekennzeichnet,**
**dass** der Sendeeinrichtung (15) ein Parallel-/Seriellwandler (18) vorgeschaltet ist.

**18.** Aktorensteuereinheit nach einem der Ansprüche 13 bis 17,
**dadurch gekennzeichnet,**
**dass** die Aktorensteuereinheit (4) eine Codiereinrichtung (19) aufweist, die über einen internen Datenbus (26) mit den Ausgängen der Speicherregister (21-25) verbunden ist.

**19.** Aktorensteuereinheit nach einem der Ansprüche 13 bis 18,
**dadurch gekennzeichnet,**
**dass** die Speicherregister (21-25) Dateneingänge aufweisen, die über einen internen Bus (20) mit dem Ausgang der Decodiereinrichtung (17) verbunden sind.

**20.** Aktorensteuereinheit nach einem der Ansprüche 13 bis 19,
**dadurch gekennzeichnet,**
**dass** den Pulweiten-Modulationseinrichtungen (28, 29, 30) Multiplexer (31, 32, 33) nachgeschaltet sind.

## Claims

**1.** Coding method for coding control commands for actuators with a system sensitive to data transmission errors, comprising the following steps:

(a) determining a degree of danger of a current transmit control command (SB) to the system by a system control (1);

(b) coding the current transmit control command (SB) to form a control command code word (SBC) by the system control (1), the redundancy of the control command code word (SBC) depending on the degree of danger to the system by the current transmit control command (SB), to be precise in such a way that the more disadvantageous the effect of transmission of the current transmit control command (SB) with errors is for the system, the higher the redundancy of the control command code word (SBC);

(c) transmitting the control command code word (SBC) from the system control (1) to an actuator control unit (4);

(d) decoding of the transmitted control command code word (SBC) by the actuator control unit (4) to form a received control command (SB');

(e) checking of the received control command (SB') for transmission errors;

(f) driving at least one actuator (6, 7, 8, 9) for carrying out the received control command (SB') if no transmission error is found.

**2.** Method according to Claim 1, **characterized in that** the system control (1) internally stores all transmit control commands ($SB_{old}$) hitherto transmitted to the actuator control unit (4).

**3.** Method according to Claim 1 or 2, **characterized in that** the current transmit control command (SB) and the transmit control commands ($SB_{old}$) hitherto transmitted to the actuator control unit are compressed by the system control (1) before they are transmitted.

**4.** Method according to one of the preceding claims, **characterized in that** the current transmit control (SB) and the control commands ($SB_{old}$) hitherto transmitted via the actuator control unit (4), which are compressed by the system control (1), are coded by the system control (1) to form the control command code word (SBC) before they are transmitted.

**5.** Method according to one of the preceding claims, **characterized in that** the actuator control unit (4) stores the received current and decoded received control command (SB') in a memory (5) of the actuator control unit (4).

**6.** Method according to one of the preceding claims, **characterized in that** the received control commands hitherto received and stored are compressed by a data compression circuit (27) in the actuator control unit (4).

**7.** Method according to Claim 6, **characterized in that** the decoded compressed sequence of control commands K (SB, $SB_{old}$) hitherto transmitted to the actuator control unit (4) are compared by a data comparison circuit (35) with the compressed control commands K(SB', $SB'_{old}$) stored in the memory (5) of the actuator unit (4), the actuator control unit (4) delivering control signals to the actuators (6, 7, 8, 9) for carrying out the control command SB' currently received if the compressed control commands are identical.

**8.** Method according to one of the preceding claims, **characterized in that** the control signals for driving the actuators (6, 7, 8, 9) are pulse width modulated.

**9.** Method according to one of the preceding claims, **characterized in that** the control command code words (SBC) are transmitted to the actuator control unit (4) via a serial bus (3).

**10.** Method according to Claim 9, **characterized in that** the serially transmitted received control command code words (SBC) are converted into parallel control command data by a serial/parallel converter (16) of the actuator control unit (4).

**11.** Method according to Claim 10, **characterized in that** the parallel converted control command data are decoded by a decoder (17).

**12.** Method according to one of the preceding claims, **characterized in that** the control commands comprise actuator setting commands, actuator status enquiry commands and actuator configuration commands.

**13.** Actuator control unit for controlling actuators in a system sensitive to data transmission errors, comprising:

(a) a transmitting and receiving device (14, 15) for connection to a serial bus (3);

(b) a decoding device for decoding control command code words SBC transmitted via the serial bus (3), the encoded redundancy of which depends on a degree of danger to the system by the coded control command (SB), to be precise in such a way that the more disadvantageous the effect of transmission of the current control command (SB) with errors is for the system, the higher the redundancy of the control command code word (SBC);

(c) a memory (5) for storing the decoded control commands;

(d) a data compression circuit for compressing the stored control commands; and comprising

(e) a data comparison circuit (35) for comparing whether the control command sequence stored in the memory (5) matches a control command sequence contained in the transmitted control command code word (SBC).

**14.** Actuator control unit according to Claim 13, **characterized in that** the memory (5) of the actuator control unit (4) consists of a number of storage registers (21, 22, 23, 24, 25) for delivering control signals to associated actuators (6, 7, 8, 9).

**15.** Actuator control unit according to Claim 13, **characterized in that** pulse width modulation devices (28, 29, 30) are provided for the pulse width modulation of the control signals.

**16.** Actuator control unit according to one of Claims 13 to 15, **characterized in that** the transmitting and receiving device (14, 15) exhibits a data receiving device (14) for receiving serial data from the system control (1) via a first data line and a transmitting device (15) for delivering serial data to the system control (1) via a second data line.

**17.** Actuator control unit according to Claim 16, **characterized in that** the transmitting device (15) is preceded by a parallel/serial converter (18).

**18.** Actuator control unit according to one of Claims 13 to 17, **characterized in that** the actuator control unit (4) exhibits a coding device (19) which is connected to the outputs of the storage registers (21-25) via an internal data bus (26).

**19.** Actuator control unit according to one of Claims 13 to 18, **characterized in that** the storage registers (21-25) exhibit data inputs which are connected to the output of the decoding device (17) via an internal bus (20).

**20.** Actuator control unit according to one of Claims 13 to 19, **characterized in that** the pulse width modulation devices (28, 29, 30) are followed by multiplexers (31, 32, 33).

## Revendications

**1.** Procédé de codage destiné à coder des instructions de commande pour des actionneurs dans un système sensible aux erreurs de transmission de données comprenant les étapes suivantes :

(a) Détermination d'un degré de risque d'une instruction de commande émise actuelle (SB) pour le système par un dispositif de commande du système (1) ;
(b) Codage de l'instruction de commande émise actuelle (SB) par le dispositif de commande du système (1) en un mot de code d'instruction de commande (SBC), la redondance du mot de code d'instruction de commande (SBC) dépendant du degré de risque de l'instruction de commande émise actuelle (SB) pour le système, et ce de telle sorte que la redondance du mot de code d'instruction de commande (SBC) est d'autant plus élevée que les inconvénients de l'effet d'une erreur de transmission de l'instruction de commande émise actuelle (SB) sont nombreux pour le système ;
(c) Transmission du mot de code d'instruction de commande (SBC) par le dispositif de commande du système (1) à une unité de commande d'actionneurs(4) ;
(d) Décodage du mot de code d'instruction de commande (SBC) transmis par l'unité de commande d'actionneurs (4) pour former une instruction de commande reçue (SB') ;
(e) Contrôle de l'instruction de commande reçue (SB') pour vérifier l'absence d'erreurs de transmission ;
(f) Commande d'au moins un actionneur (6, 7, 8, 9) pour exécuter l'instruction de commande reçue (SB') si aucune erreur de transmission n'est constatée.

**2.** Procédé selon la revendication 1, **caractérisé en ce que** le dispositif de commande du système (1) mémorise en interne toutes les instructions de commande émises transmises antérieurement ($SB_{antérieure}$) à l'unité de commande d'actionneurs (4).

**3.** Procédé selon la revendication 1 ou 2, **caractérisé en ce que** l'instruction de commande émise actuelle (SB) et les instructions de commande émises transmises antérieurement à l'unité de commande d'actionneurs ($SB_{antérieure}$) sont comprimées avant la transmission par le dispositif de commande du système (1).

**4.** Procédé selon l'une des revendications précédentes, **caractérisé en ce que** l'instruction de commande émise actuelle (SB) et les instructions de commande transmises antérieurement ($SB_{antérieure}$) par l'unité de commande d'actionneurs (4), lesquelles sont comprimées par le dispositif de commande du système (1), sont codées par le système de commande du système (1) avant la transmission en vue de former le mot de code d'instruction de commande (SBC).

**5.** Procédé selon l'une des revendications précédentes, **caractérisé en ce que** l'unité de commande d'actionneurs (4) enregistre l'instruction de commande reçue actuellement reçue et décodée (SB') dans une mémoire (5) de l'unité de commande d'actionneurs (4).

**6.** Procédé selon l'une des revendications précédentes, **caractérisé en ce que** les instructions de commande reçues et enregistrées antérieurement sont comprimées dans l'unité de commande d'actionneurs (4) par un circuit de compression de données (27).

**7.** Procédé selon la revendication 6, **caractérisé en ce que** la séquence comprimée décodée des instructions de commande K(SB, $SB_{antérieure}$) transmises antérieurement à l'unité de commande d'actionneurs (4) est comparée avec les instructions de commande K(SB', $SB'_{antérieure}$) comprimées enregistrées dans la mémoire (5) de l'unité de commande d'actionneurs (4) par un circuit comparateur de données (35), l'unité de commande d'actionneurs (4), si les instructions de commande comprimées sont identiques, délivrant aux actionneurs (6, 7, 8, 9) les signaux de commande pour exécuter l'instruction de commande reçue actuelle (SB').

**8.** Procédé selon l'une des revendications précédentes, **caractérisé en ce que** les signaux de commande destinés à la commande des actionneurs (6, 7, 8, 9) sont modulés en largeur d'impulsion.

**9.** Procédé selon l'une des revendications précédentes, **caractérisé en ce que** les mots de code d'instruction de commande (SBC) sont transmis à l'unité de commande d'actionneurs (4) par le biais d'un bus série (3).

**10.** Procédé selon la revendication 9, **caractérisé en ce que** les mots de code d'instruction de commande (SBC) transmis en série reçus sont convertis en données d'instruction de commande parallèles par un convertisseur série/parallèle (16) de l'unité de commande d'actionneurs (4).

**11.** Procédé selon la revendication 10, **caractérisé en ce que** les données d'instruction de commande converties en parallèle sont décodées par un décodeur (17).

**12.** Procédé selon l'une des revendications précédentes, **caractérisé en ce que** les instructions de commande comprennent des instructions de réglage des actionneurs, des instructions d'interrogation de l'état des actionneurs et des instructions de configuration des actionneurs.

**13.** Unité de commande d'actionneurs pour commander des actionneurs dans un système sensible aux erreurs de transmission de données comprenant :

(a) un dispositif d'émission et de réception (14, 15) pour le raccordement à un bus série (3) ;
(b) un dispositif de décodage pour décoder les mots de code d'instruction de commande (SBC) transmis par le biais du bus série (3) et dont la redondance codée dépend du degré de risque de l'instruction de commande codée (SB) pour le système, et ce de telle sorte que la redondance du mot de code d'instruction de commande (SBC) est d'autant plus élevée que les inconvénients de l'effet d'une erreur de transmission de l'instruction de commande actuelle (SB) sont nombreux pour le système ;
(c) une mémoire (5) pour enregistrer les instructions de commande décodées ;
(d) un dispositif de compression de données pour comprimer les instructions de commande enregistrées ; et comprenant
(e) un circuit comparateur de données (35) pour vérifier par comparaison si la séquence d'instructions de commande enregistrée dans la mémoire (5) concorde avec une séquence d'instructions de commande contenue dans le mot de code d'instruction de commande (SBC) transmis.

**14.** Unité de commande d'actionneurs selon la revendication 13, **caractérisée en ce que** la mémoire (5) de l'unité de commande d'actionneurs (4) se compose de plusieurs registres de mémoire (21, 22, 23, 24, 25) pour délivrer des signaux de commande aux actionneurs correspondants (6, 7, 8, 9) .

**15.** Unité de commande d'actionneurs selon la revendication 13, **caractérisée en ce que** des dispositifs de modulation en largeur d'impulsion (28, 29, 30) sont prévus pour la modulation en largeur d'impulsion des signaux de commande.

**16.** Unité de commande d'actionneurs selon l'une des revendications 13 à 15, **caractérisée en ce que** le dispositif d'émission et de réception (14, 15) présente un dispositif de réception de données (14) pour recevoir les données série du dispositif de commande du système (1) par le biais d'une première ligne de données et un dispositif d'émission (15) pour délivrer les données série au dispositif de commande du système (1) par le biais d'une deuxième ligne de données.

**17.** Unité de commande d'actionneurs selon la revendication 16, **caractérisée en ce qu'**un convertisseur parallèle/série (18) est branché avant le dispositif d'émission (15).

**18.** Unité de commande d'actionneurs selon l'une des revendications 13 à 17, **caractérisée en ce que** l'unité de commande d'actionneurs (4) présente un dispositif de codage (19) qui est relié aux sorties des registres de mémoire (21-25) par le biais d'un bus de données interne (26).

**19.** Unité de commande d'actionneurs selon l'une des revendications 13 à 18, **caractérisée en ce que** les registres de mémoire (21-25) présentent des entrées de données qui sont reliées à la sortie du dispositif de décodage (17) par le biais d'un bus interne (20).

**20.** Unité de commande d'actionneurs selon l'une des revendication 13 à 19, **caractérisée en ce que** des multiplexeurs (31, 32, 33) sont branchés à la suite des dispositifs de modulation en largeur d'impulsion (28, 29, 30).

FIG 1

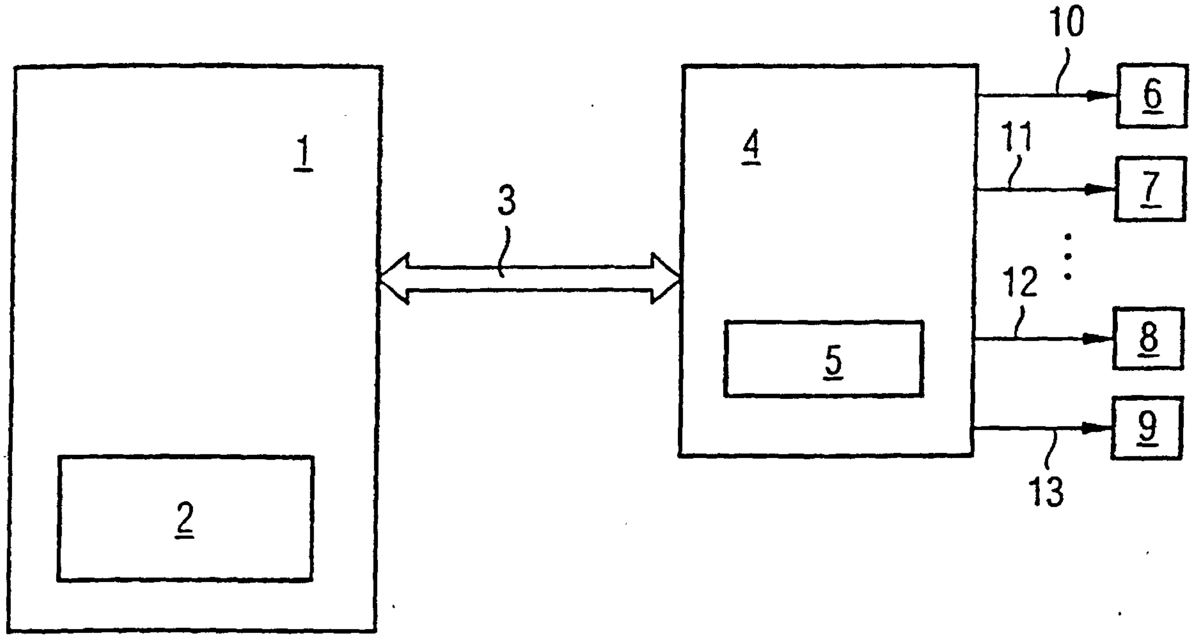

FIG 2A

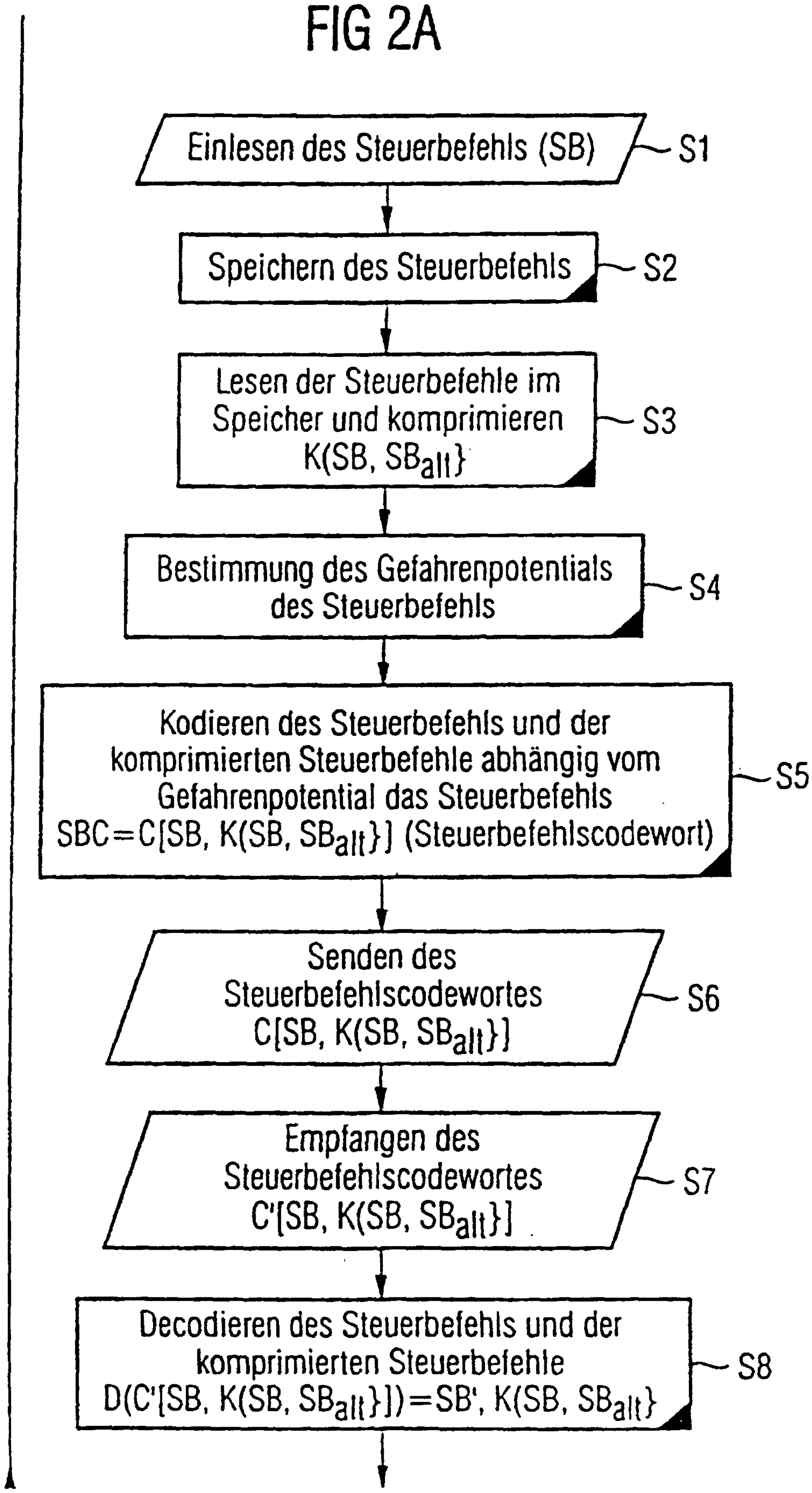
Einlesen des Steuerbefehls (SB)
S1
Speichern des Steuerbefehls
S2
Lesen der Steuerbefehle im Speicher und komprimieren K(SB, SBalt}
S3
Bestimmung des Gefahrenpotentials des Steuerbefehls
S4
Kodieren des Steuerbefehls und der komprimierten Steuerbefehle abhängig vom Gefahrenpotential das Steuerbefehls SBC=C[SB, K(SB, SBalt}] (Steuerbefehlscodewort)
S5
Senden des Steuerbefehlscodewortes C[SB, K(SB, SBalt}]
S6
Empfangen des Steuerbefehlscodewortes C'[SB, K(SB, SBalt}]
S7
Decodieren des Steuerbefehls und der komprimierten Steuerbefehle D(C'[SB, K(SB, SBalt}])=SB', K(SB, SBalt}
S8

FIG 2B

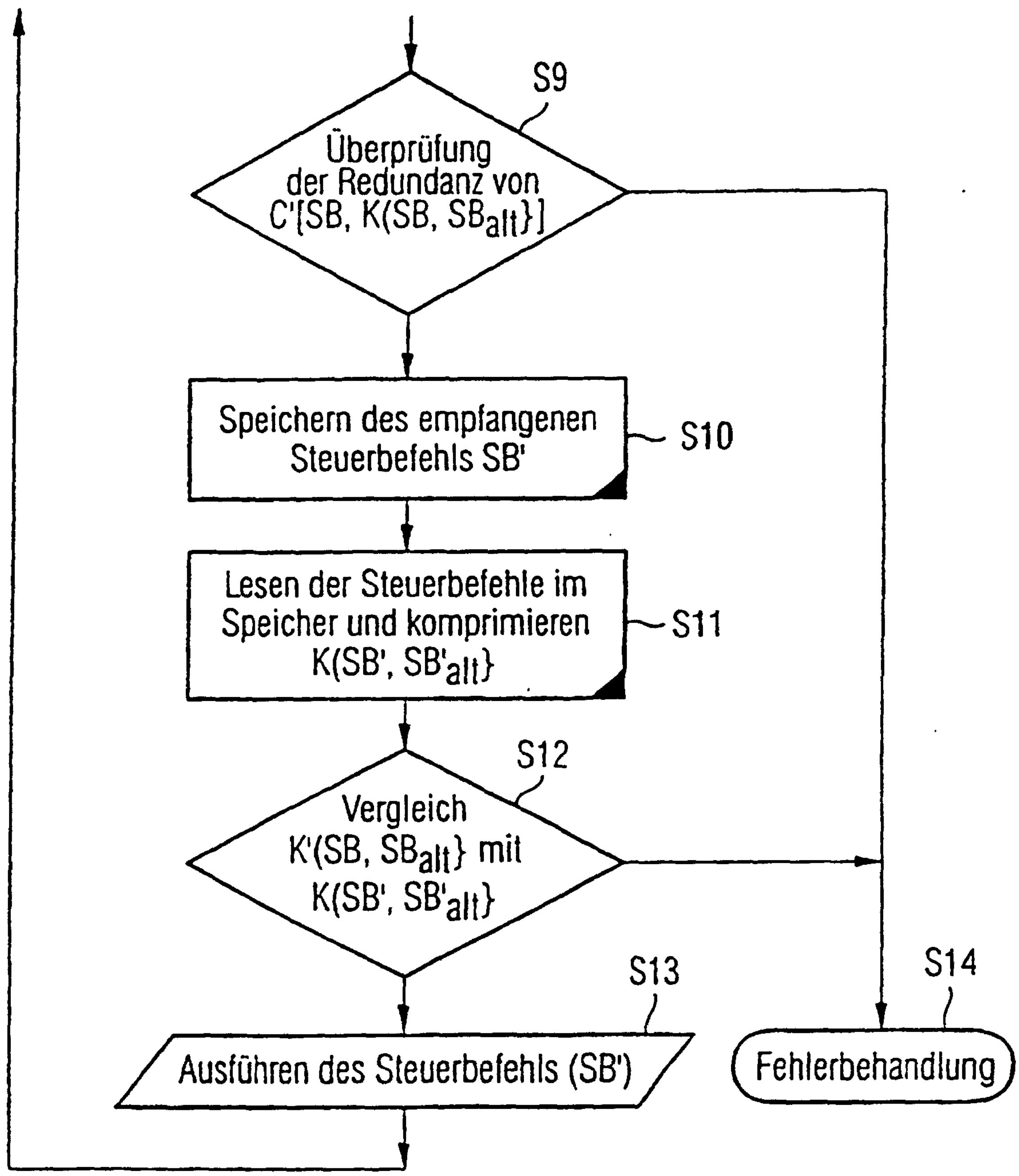
S9
Überprüfung der Redundanz von C'[SB, K(SB, SBalt}]
Speichern des empfangenen Steuerbefehls SB'
S10
Lesen der Steuerbefehle im Speicher und komprimieren K(SB', SB'alt}
S11
S12
Vergleich K'(SB, SBalt} mit K(SB', SB'alt}
S13
S14
Ausführen des Steuerbefehls (SB')
Fehlerbehandlung

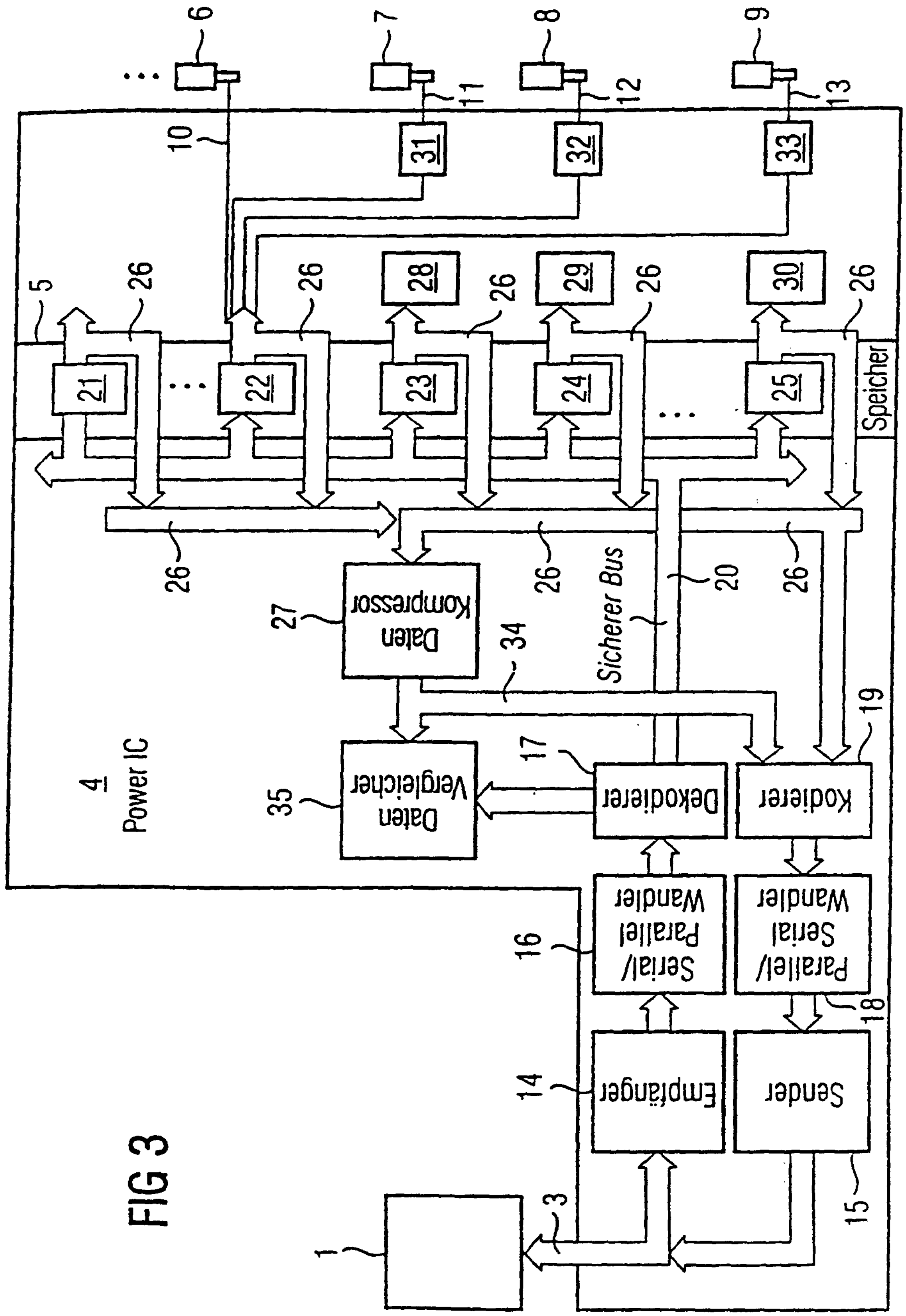
Power IC
Speicher
Sicherer Bus
Daten Kompressor
Daten Vergleicher
Dekodierer
Kodierer
Serial/ Parallel Wandler
Parallel/ Serial Wandler
Empfänger
Sender

FIG 3

## FIG 4A

Format des Steuerbefehls-Code-Wortes:

| | | | | |
|---|---|---|---|---|
| Ventil Kontrolle (Hohes Gafahrenpotential) | 1 Bit Opcode | 9 Bit Ventil Stellung | 5 Bit K{SB, $SB_{alt}$} | |
| Ventil Kontrolle (Normales Gefahrenpotential) | 1 Bit Opcode | 11 Bit Ventil Steuerung | 4 Bit K{SB, $SB_{alt}$} | |
| Status Abfrage | 3 Bit Opcode | 4 Bit Adresse des Statusregisters | 9 Bit Nicht verwendet | |
| Konfigurations-Kontrolle | 3 Bit Opcode | 8 Bit Konfiguration | 5 Bit K{SB, $SB_{alt}$} | |
| PWM Kontrolle | 2 Bit Opcode | 2 Bit Ventil Nummer | 8 Bit PWM | 4 Bit K{SB, $SB_{alt}$} |

## FIG 4B

Format des Rückgabewertes:

| | | | | |
|---|---|---|---|---|
| PWM Kontrolle | 1 Bit Fehlerzustand | 5 Bit K{SB, $SB_{alt}$} | 2 Bit Ventil Nummer | 8 Bit PWM |
| Ventil Kontrolle | 1 Bit Fehlerzustand | 5 Bit K{SB, $SB_{alt}$} | 10 Bit Ventil Zustand | |
| Status Abfrage | 1 Bit Fehlerzustand | 5 Bit K{SB, $SB_{alt}$} | 10 Bit Status | |
| Konfigurations-Kontrolle | 1 Bit Fehlerzustand | 5 Bit K{SB, $SB_{alt}$} | 2 Bit Fehler Klasse | 8 Bit Konfiguration |

# FIG 4C(1)

| Kodierung | Code Bits | K{} Bits | Rad 1 | Rad 2 | Rad 3 | Rad 4 | Gefährdungs-potential | Einlass Ventil Rad 1 | Auslass Ventil Rad 1 | Einlass Ventil Rad 2 | Auslass Ventil Rad 2 | Einlass Ventil Rad 3 | Auslass Ventil Rad 3 | Einlass Ventil Rad 4 | Auslass Ventil Rad 4 |
|---|---|---|---|---|---|---|---|---|---|---|---|---|---|---|---|
| 10000000vvvvcccccc | 11 | 4 | Bremsen | Bremsen | Bremsen | Druck halten | 3 Räder normale Bremsfunktion (niedrig) | offen | zu | offen | zu | offen | zu | zu | zu |
| 10000001vvvvcccccc | 11 | 4 | Bremsen | Bremsen | Druck halten | Bremsen | | offen | zu | offen | zu | zu | zu | offen | zu |
| 10000010vvvvcccccc | 11 | 4 | Bremsen | Druck halten | Bremsen | Bremsen | | offen | zu | zu | zu | offen | zu | offen | zu |
| 10000011vvvvcccccc | 11 | 4 | Druck halten | Bremsen | Bremsen | Bremsen | | zu | zu | zu | zu | offen | zu | offen | zu |
| 10000100vvvvcccccc | 11 | 4 | Bremsen | Bremsen | Bremsen | Druck Abbauen | | offen | zu | offen | zu | offen | zu | zu | offen |
| 10000101vvvvcccccc | 11 | 4 | Bremsen | Bremsen | Druck Abbauen | Bremsen | | offen | zu | offen | zu | zu | offen | offen | zu |
| 10000110vvvvcccccc | 11 | 4 | Bremsen | Druck Abbauen | Bremsen | Bremsen | | offen | zu | zu | offen | offen | zu | offen | zu |
| 10000111vvvvcccccc | 11 | 4 | Druck Abbauen | Bremsen | Bremsen | Bremsen | | zu | offen | zu | zu | offen | zu | offen | zu |
| 10100000vvvvcccccc | 11 | 4 | Bremsen | Druck halten | Druck halten | Druck halten | 1 Rad normale Bremsfunktion (niedrig) | offen | zu | zu | zu | zu | zu | zu | zu |
| 10100001vvvvcccccc | 11 | 4 | Druck halten | Bremsen | Druck halten | Druck halten | | zu | zu | offen | zu | zu | zu | zu | zu |
| 10100010vvvvcccccc | 11 | 4 | Druck halten | Druck halten | Bremsen | Druck halten | | zu | zu | zu | zu | offen | zu | zu | zu |
| 10100011vvvvcccccc | 11 | 4 | Druck halten | Druck halten | Druck halten | Bremsen | | zu | zu | zu | zu | zu | zu | offen | zu |
| 10100100vvvvcccccc | 11 | 4 | Bremsen | Druck halten | Druck halten | Druck Abbauen | | offen | zu | zu | zu | zu | zu | zu | offen |
| 10100101vvvvcccccc | 11 | 4 | Bremsen | Druck halten | Druck Abbauen | Druck halten | | offen | zu | zu | zu | zu | offen | zu | zu |
| 10100110vvvvcccccc | 11 | 4 | Bremsen | Druck Abbauen | Druck halten | Druck halten | | offen | zu | zu | offen | zu | zu | zu | zu |

FIG 4C(2)

| Kodierung | Code Bits | K{} Bits | Rad 1 | Rad 2 | Rad 3 | Rad 4 | Gefährdungs-potential | Einlass Ventil Rad 1 | Auslass Ventil Rad 1 | Einlass Ventil Rad 2 | Auslass Ventil Rad 2 | Einlass Ventil Rad 3 | Auslass Ventil Rad 3 | Einlass Ventil Rad 4 | Auslass Ventil Rad 4 |
|---|---|---|---|---|---|---|---|---|---|---|---|---|---|---|---|
| 10100111vvvvcccccc | 11 | 4 | Druck halten | Bremsen | Druck halten | Druck Abbauen | | zu | zu | offen | zu | zu | zu | zu | offen |
| 10101000vvvvcccccc | 11 | 4 | Druck halten | Bremsen | Druck Abbauen | Druck halten | | zu | zu | offen | zu | zu | offen | zu | zu |
| 10101001vvvvcccccc | 11 | 4 | Druck Abbauen | Bremsen | Druck halten | Druck halten | | zu | offen | offen | zu | zu | zu | zu | zu |
| 10101010vvvvcccccc | 11 | 4 | Druck halten | Druck halten | Bremsen | Druck Abbauen | | zu | zu | zu | zu | offen | zu | zu | offen |
| 10101011vvvvcccccc | 11 | 4 | Druck halten | Druck Abbauen | Bremsen | Druck halten | | zu | zu | zu | offen | offen | zu | zu | zu |
| 10101100vvvvcccccc | 11 | 4 | Druck Abbauen | Druck halten | Bremsen | Druck halten | | zu | offen | zu | zu | offen | zu | zu | zu |
| 10101101vvvvcccccc | 11 | 4 | Druck halten | Druck halten | Druck Abbauen | Bremsen | | zu | zu | zu | zu | zu | offen | offen | zu |
| 10101110vvvvcccccc | 11 | 4 | Druck halten | Druck Abbauen | Druck halten | Bremsen | | zu | zu | zu | offen | zu | zu | offen | zu |
| 10101111vvvvcccccc | 11 | 4 | Druck Abbauen | Druck halten | Druck halten | Bremsen | | zu | offen | zu | zu | zu | zu | offen | zu |
| 10110000vvvvcccccc | 11 | 4 | Bremsen | Druck Abbauen | Druck Abbauen | Druck halten | | offen | zu | zu | offen | zu | offen | zu | zu |
| 10110001vvvvcccccc | 11 | 4 | Bremsen | Druck Abbauen | Druck halten | Druck Abbauen | | offen | zu | zu | offen | zu | zu | zu | offen |
| 10110010vvvvcccccc | 11 | 4 | Bremsen | Druck halten | Druck Abbauen | Druck Abbauen | | offen | zu | zu | zu | zu | offen | zu | offen |
| 10110011vvvvcccccc | 11 | 4 | Druck Abbauen | Bremsen | Druck halten | Druck Abbauen | | zu | offen | offen | zu | zu | zu | zu | offen |
| 10110100vvvvcccccc | 11 | 4 | Druck halten | Bremsen | Druck Abbauen | Druck Abbauen | | zu | zu | offen | zu | zu | offen | zu | offen |
| 10110101vvvvcccccc | 11 | 4 | Druck Abbauen | Bremsen | Druck Abbauen | Druck halten | | zu | offen | offen | zu | zu | offen | zu | zu |
| 10110110vvvvcccccc | 11 | 4 | Druck Abbauen | Druck halten | Bremsen | Druck Abbauen | | zu | offen | zu | zu | offen | zu | zu | offen |

# FIG 4C(3)

| Kodierung | Code Bits | K{} Bits | Rad 1 | Rad 2 | Rad 3 | Rad 4 | Gefährdungs-potential | Einlass Ventil Rad 1 | Auslass Ventil Rad 1 | Einlass Ventil Rad 2 | Auslass Ventil Rad 2 | Einlass Ventil Rad 3 | Auslass Ventil Rad 3 | Einlass Ventil Rad 4 | Auslass Ventil Rad 4 |
|---|---|---|---|---|---|---|---|---|---|---|---|---|---|---|---|
| 10110111vvvvcccccc | 11 | 4 | Druck Abbauen | Druck Abbauen | Bremsen | Druck halten | | zu | offen | zu | offen | offen | zu | zu | zu |
| 10111000vvvvcccccc | 11 | 4 | Druck halten | Druck Abbauen | Bremsen | Druck Abbauen | | zu | zu | zu | offen | offen | zu | offen | offen |
| 10111001vvvvcccccc | 11 | 4 | Druck Abbauen | Druck Abbauen | Druck halten | Bremsen | | zu | offen | zu | offen | zu | zu | offen | zu |
| 10111010vvvvcccccc | 11 | 4 | Druck Abbauen | Druck halten | Druck Abbauen | Bremsen | | zu | offen | zu | zu | zu | offen | offen | zu |
| 10111011vvvvcccccc | 11 | 4 | Druck halten | Druck Abbauen | Druck Abbauen | Bremsen | | zu | zu | zu | offen | zu | offen | offen | zu |
| 10111100vvvvcccccc | 11 | 4 | Bremsen | Druck Abbauen | Druck Abbauen | Druck Abbauen | | offen | zu | zu | offen | zu | offen | zu | offen |
| 10111101vvvvcccccc | 11 | 4 | Druck Abbauen | Bremsen | Druck Abbauen | Druck Abbauen | | zu | offen | offen | zu | zu | offen | zu | offen |
| 10001000vvvvcccccc | 11 | 4 | Bremsen | Bremsen | Druck halten | Druck halten | 2 Vorder-räder normale Bremsfunktion (niedrig) | offen | zu | offen | zu | zu | zu | zu | zu |
| 10001001vvvvcccccc | 11 | 4 | Bremsen | Bremsen | Druck halten | Druck Abbauen | | offen | zu | offen | zu | zu | zu | zu | offen |
| 10001010vvvvcccccc | 11 | 4 | Bremsen | Bremsen | Druck Abbauen | Druck halten | | offen | zu | offen | zu | zu | offen | zu | zu |
| 10001011vvvvcccccc | 11 | 4 | Bremsen | Bremsen | Druck Abbauen | Druck Abbauen | | offen | zu | offen | zu | zu | offen | zu | offen |
| 10001100vvvvcccccc | 11 | 4 | Druck halten | Druck halten | Bremsen | Bremsen | 2 Hinter-räder normale Bremsfunktion (niedrig) | zu | zu | zu | zu | offen | zu | offen | zu |
| 10001101vvvvcccccc | 11 | 4 | Druck Abbauen | Druck halten | Bremsen | Bremsen | | zu | offen | zu | zu | offen | zu | offen | zu |
| 10001110vvvvcccccc | 11 | 4 | Druck halten | Druck Abbauen | Bremsen | Bremsen | | zu | zu | zu | offen | offen | zu | offen | zu |
| 10001111vvvvcccccc | 11 | 4 | Druck Abbauen | Druck Abbauen | Bremsen | Bremsen | | zu | offen | zu | offen | offen | zu | offen | zu |

FIG 4C(4)

| Kodierung | Code Bits | K{} Bits | Rad 1 | Rad 2 | Rad 3 | Rad 4 | Gefährdungs-potential | Einlass Ventil Rad 1 | Auslass Ventil Rad 1 | Einlass Ventil Rad 2 | Auslass Ventil Rad 2 | Einlass Ventil Rad 3 | Auslass Ventil Rad 3 | Einlass Ventil Rad 4 | Auslass Ventil Rad 4 |
|---|---|---|---|---|---|---|---|---|---|---|---|---|---|---|---|
| 10010000vvvvcccccc | 11 | 4 | Bremsen | Druck halten | Druck halten | Bremsen | 1 linkes und ein rechtes Rad normale Bremsfunktion (niedrig) | offen | zu | zu | zu | zu | zu | offen | zu |
| 10010001vvvvcccccc | 11 | 4 | Druck halten | Bremsen | Bremsen | Druck halten | | zu | zu | offen | offen | zu | zu | zu | zu |
| 10010010vvvvcccccc | 11 | 4 | Bremsen | Druck halten | Druck Abbauen | Bremsen | | offen | zu | zu | zu | zu | offen | offen | zu |
| 10010011vvvvcccccc | 11 | 4 | Bremsen | Druck Abbauen | Druck halten | Bremsen | | offen | zu | zu | offen | zu | zu | offen | zu |
| 10010100vvvvcccccc | 11 | 4 | Druck halten | Bremsen | Bremsen | Druck Abbauen | | zu | zu | zu | zu | zu | zu | zu | offen |
| 10010101vvvvcccccc | 11 | 4 | Druck Abbauen | Bremsen | Bremsen | Druck halten | | zu | offen | offen | zu | offen | zu | zu | zu |
| 10010110vvvvcccccc | 11 | 4 | Bremsen | Druck Abbauen | Druck Abbauen | Bremsen | | zu | zu | zu | offen | zu | offen | offen | zu |
| 10010111vvvvcccccc | 11 | 4 | Druck Abbauen | Bremsen | Bremsen | Druck Abbauen | | zu | offen | offen | zu | offen | zu | zu | offen |
| 10011000vvvvcccccc | 11 | 4 | Bremsen | Druck halten | Bremsen | Druck halten | 2 linke bzw. rechte Räder normale Bremsfunktion (niedrig) | offen | zu | zu | zu | offen | zu | zu | zu |
| 10011001vvvvcccccc | 11 | 4 | Druck halten | Bremsen | Druck halten | Bremsen | | zu | zu | offen | zu | zu | zu | offen | zu |
| 10011010vvvvcccccc | 11 | 4 | Bremsen | Druck halten | Bremsen | Druck Abbauen | | offen | zu | zu | zu | offen | zu | zu | offen |
| 10011011vvvvcccccc | 11 | 4 | Bremsen | Druck Abbauen | Bremsen | Druck halten | | offen | zu | zu | offen | offen | zu | zu | zu |
| 10011100vvvvcccccc | 11 | 4 | Bremsen | Druck Abbauen | Bremsen | Druck Abbauen | | offen | zu | zu | offen | offen | zu | zu | offen |
| 10011101vvvvcccccc | 11 | 4 | Druck halten | Bremsen | Druck Abbauen | Bremsen | | zu | zu | offen | zu | zu | offen | offen | zu |
| 10011110vvvvcccccc | 11 | 4 | Druck Abbauen | Bremsen | Druck halten | Bremsen | | zu | offen | offen | zu | zu | zu | offen | zu |
| 10011111vvvvcccccc | 11 | 4 | Druck Abbauen | Bremsen | Druck Abbauen | Bremsen | | zu | offen | offen | zu | zu | offen | offen | zu |

# FIG 4C(5)

| Kodierung | Code Bits | K{} Bits | Rad 1 | Rad 2 | Rad 3 | Rad 4 | Gefährdungs-potential | Einlass Ventil Rad 1 | Auslass Ventil Rad 1 | Einlass Ventil Rad 2 | Auslass Ventil Rad 2 | Einlass Ventil Rad 3 | Auslass Ventil Rad 3 | Einlass Ventil Rad 4 | Auslass Ventil Rad 4 |
|---|---|---|---|---|---|---|---|---|---|---|---|---|---|---|---|
| 10111110vvvvccccc | 11 | 4 | Druck Abbauen | Druck Abbauen | Bremsen | Druck Abbauen | | zu | offen | zu | offen | offen | zu | zu | offen |
| 10111111vvvvccccc | 11 | 4 | Druck Abbauen | Druck Abbauen | Druck Abbauen | Bremsen | | zu | offen | zu | offen | zu | offen | offen | zu |
| 110000vvvvcccccc | 9 | 6 | Druck halten | Druck halten | Druck halten | Druck halten | 0 Rad normale Bremsfunktion (hoch) | zu | zu | zu | zu | zu | zu | zu | zu |
| 110001vvvvcccccc | 9 | 6 | Druck halten | Druck halten | Druck halten | Druck Abbauen | | zu | zu | zu | zu | zu | zu | zu | offen |
| 110010vvvvcccccc | 9 | 6 | Druck halten | Druck halten | Druck Abbauen | Druck halten | | zu | zu | zu | zu | zu | offen | zu | zu |
| 110011vvvvcccccc | 9 | 6 | Druck halten | Druck Abbauen | Druck halten | Druck halten | | zu | zu | zu | offen | zu | zu | zu | zu |
| 110100vvvvcccccc | 9 | 6 | Druck Abbauen | Druck halten | Druck halten | Druck halten | | zu | offen | zu | zu | zu | zu | zu | zu |
| 110101vvvvcccccc | 9 | 6 | Druck halten | Druck halten | Druck Abbauen | Druck Abbauen | | zu | zu | zu | zu | zu | offen | zu | offen |
| 110110vvvvcccccc | 9 | 6 | Druck Abbauen | Druck Abbauen | Druck halten | Druck halten | | zu | offen | zu | offen | zu | zu | zu | zu |
| 110111vvvvcccccc | 9 | 6 | Druck halten | Druck Abbauen | Druck Abbauen | Druck halten | | zu | zu | zu | offen | zu | offen | zu | zu |

# FIG 4C(6)

| Kodierung | Code Bits | K{} Bits | Rad 1 | Rad 2 | Rad 3 | Rad 4 | Gefährdungs-potential | Einlass Ventil Rad 1 | Auslass Ventil Rad 1 | Einlass Ventil Rad 2 | Auslass Ventil Rad 2 | Einlass Ventil Rad 3 | Auslass Ventil Rad 3 | Einlass Ventil Rad 4 | Auslass Ventil Rad 4 |
|---|---|---|---|---|---|---|---|---|---|---|---|---|---|---|---|
| 111000vvvvcccccc | 9 | 6 | Druck Abbauen | Druck halten | Druck Abbauen | Druck halten | | zu | offen | zu | zu | zu | offen | zu | zu |
| 111001vvvvcccccc | 9 | 6 | Druck Abbauen | Druck halten | Druck halten | Druck Abbauen | | zu | offen | zu | zu | zu | zu | zu | offen |
| 111010vvvvcccccc | 9 | 6 | Druck halten | Druck Abbauen | Druck halten | Druck Abbauen | | zu | zu | zu | offen | zu | zu | zu | offen |
| 111011vvvvcccccc | 9 | 6 | Druck halten | Druck Abbauen | Druck Abbauen | Druck Abbauen | | zu | zu | zu | offen | zu | offen | zu | offen |
| 111100vvvvcccccc | 9 | 6 | Druck Abbauen | Druck halten | Druck Abbauen | Druck Abbauen | | zu | offen | zu | zu | zu | offen | zu | offen |
| 111101vvvvcccccc | 9 | 6 | Druck Abbauen | Druck Abbauen | Druck halten | Druck Abbauen | | zu | offen | zu | offen | zu | zu | zu | offen |
| 111110vvvvcccccc | 9 | 6 | Druck Abbauen | Druck Abbauen | Druck Abbauen | Druck halten | | zu | offen | zu | offen | zu | offen | zu | zu |
| 111111vvvvcccccc | 9 | 6 | Druck Abbauen | Druck Abbauen | Druck Abbauen | Druck Abbauen | | zu | offen | zu | offen | zu | offen | zu | offen |